# EUROPEAN PATENT SPECIFICATION

(11) **EP 4 075 404 B1**
(45) Date of publication and mention of the grant of the patent: **08.04.2026**
(21) Application number: 20912207.6
(22) Date of filing: 07.01.2020
(51) Int. Cl.: G08C 17/00

(54) **CONTROL CIRCUIT, CONTROL METHOD FOR SWITCH TRANSISTOR AND COMPUTER-READABLE STORAGE MEDIUM**
STEUERSCHALTUNG, STEUERVERFAHREN FÜR EINEN SCHALTTRANSISTOR UND COMPUTERLESBARES SPEICHERMEDIUM
CIRCUIT DE COMMANDE, PROCÉDÉ DE COMMANDE POUR TRANSISTOR DE COMMUTATION ET SUPPORT DE STOCKAGE LISIBLE PAR ORDINATEUR

(43) Date of publication of application: 19.10.2022
(73) Proprietor: GUANGDONG OPPO MOBILE TELECOMMUNICATIONS CORP., LTD., Dongguan, Guangdong 523860 (CN)
(72) Inventor: TIAN, Chen, Dongguan, Guangdong 523860 (CN); ZHANG, Jialiang, Dongguan, Guangdong 523860 (CN)
(74) Representative: Thorniley, Peter
(86) International application number: PCT/CN2020/070774
(87) International publication number: WO 2021/138819

(56) References cited:
- WO-A1-2011/093035
- CN-A- 101 261 764
- CN-A- 101 261 764
- CN-A- 102 185 448
- CN-A- 104 242 714
- CN-A- 104 852 442
- CN-A- 109 638 797
- US-A1- 2015 069 850

## Description

### FIELD

Embodiments of the present disclosure relate to the field of control technologies, and more particularly, to a control circuit and a control method for a switch transistor, as well as a computer-readable storage medium.

### BACKGROUND

Currently, in the field of power electronics technologies, power semiconductor devices are mainly applied in power transmission and transformation, steel smelting, motor drive, rail transportation, power supply, and other fields. To ensure stable operation of a power supply/inverter system and improve reliability of the system, the control technology of power semiconductor devices is particularly important.

At present, transformer control, capacitor control, and optocoupler control can be used. However, with these control methods, when an output of a control unit is at a high frequency, on the one hand, there are limitations in terms of setting dead time of a control signal, thereby leading to low efficiency, and causing crosstalk in the circuit; and on the other hand, there are limitations in terms of setting a position of the control unit, thereby leading to a crosstalk in the circuit and a mistaken turn-on of the switch transistor. CN 101 261 764 A relates to a wireless drive system of a power switching device in the field of electric power and electronic technology. US 2015/069850 A1 provides an electronic system including a standby mode without electrical consumption.

### SUMMARY

Embodiments of the present disclosure provide a control circuit and a control method for a switch transistor, as well as a computer-readable storage medium. The invention is set out in the appended set of claims. At high output frequencies, the efficiency can be improved by shortening a dead time of a control signal without causing crosstalk in the circuit. In addition, by using a microwave unit to control turn-on and turn-off of a switch transistor, a relatively long distance between a transmitting terminal and a receiving terminal of the microwave unit can be set to further avoid the crosstalk in the circuit and also prevent the switch transistor from being turned on by mistake.

With the control circuit according to the embodiments of the present disclosure, in a process of transmitting the control signal, the transmitting terminal of the microwave unit can convert the control signal into the microwave signal and transmit the microwave signal to the receiving terminal of the microwave unit, and the receiving terminal can convert the microwave signal into the control signal after receiving the microwave signal, such that the switch transistor can be turned on or off under to control of the converted control signal. On the one hand, due to a high response speed of the microwave unit, the transmitting terminal of the microwave unit can convert the control signal into the microwave signal and quickly transmit the microwave signal to the receiving terminal. Therefore, even if the dead time of the control signal is set to be short, the switch transistor can be turned on or off quickly without causing crosstalk in the circuit. On the other hand, since the microwaves can be transmitted without depending upon any medium, a distance between the transmitting terminal and the receiving terminal of the microwave unit can be relatively long, thereby further avoiding the crosstalk in the circuit and preventing the switch transistor from being mistakenly turned on.

### BRIEF DESCRIPTION OF DRAWINGS

FIG. 1 is a structural schematic diagram of a control circuit for controlling a Metal Oxide Semiconductor (MOS) transistor according to an example useful for understanding the invention but outside the scope of the invention as claimed.
FIG. 2 is a structural schematic diagram of a control circuit according to an embodiment of the present disclosure.
FIG. 3a is a structural schematic diagram of a control circuit according to another embodiment of the present disclosure.
FIG. 3b is a structural schematic diagram of a control circuit according to yet another embodiment of the present disclosure.
FIG. 4a is a structural schematic diagram of a control circuit according to still yet another embodiment of the present disclosure.
FIG. 4b is a structural schematic diagram of a control circuit according to still yet another embodiment of the present disclosure.
FIG. 4c is a structural schematic diagram of a control circuit according to still yet another embodiment of the present disclosure.
FIG. 5 is a structural schematic diagram of a control circuit according to still yet another embodiment of the present disclosure.
FIG. 6 is a schematic diagram of a control signal according to an embodiment of the present disclosure.
FIG. 7 is a structural schematic diagram of a control circuit according to still yet another embodiment of the present disclosure.
FIG. 8 is a schematic flowchart of a control method for a switch transistor according to an embodiment of the present disclosure.

### DESCRIPTION OF EMBODIMENTS

Technical solutions according to embodiments of the present disclosure will be described clearly and thoroughly below in combination with accompanying drawings. Obviously, the embodiments described below are only a part of, rather than all of the embodiments of the present disclosure. On basis of the embodiments of the present disclosure, all other embodiments obtained by those skilled in the art without paying creative effort shall fall within the protection scope of the present disclosure.

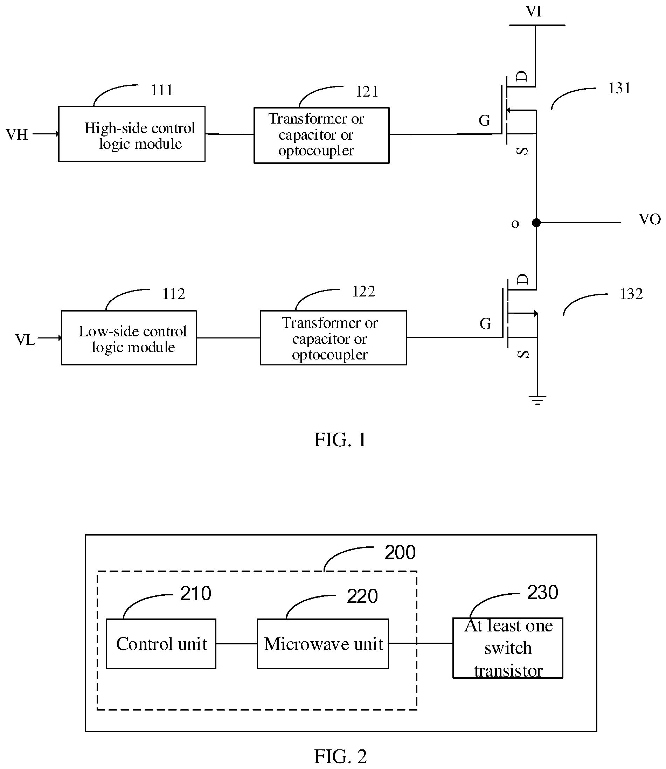

In order to understand the present disclosure more clearly, the working principle and processes of the control circuit will be described below in combination with FIG. 1 to facilitate subsequent understanding of the solutions of the present disclosure. However, it should be understood that the following description is only for better understanding of the present disclosure and should not be construed as specific limitations on the present disclosure.

FIG. 1 is a structural schematic diagram of a control circuit for controlling a Metal Oxide Semiconductor (MOS) transistor according to an example useful for understanding the invention but outside the scope of the invention as claimed. Here, the MOS transistor, also known as a Metal Oxide Semiconductor Field Effect Transistor (MOSFET), belongs to insulated gate transistors of field effect transistors.

As illustrated in FIG. 1, in general, a high-side control logic module 111 and a low-side control logic module 112 may control turn-on and turn-off of a high-side MOS transistor 131 and a low-side MOS transistor 132 in stages. Here, the high-side MOS transistor 131 and the low-side MOS transistor 132 may be MOS transistors in a half-bridge circuit.

When a signal outputted by the high-side control logic module 111 is at a high level, the high-side MOS transistor 131 is turned on and the low-side MOS transistor 132 is turned off. Since a drain of the high-side MOS transistor 131 is connected to a power supply V₁, a high-level voltage V_{I} is outputted at an output point o in this case, i.e., Vo = V_{I}.

When a signal outputted by the low-side control logic module 112 is at a low level, the low-side MOS transistor 132 is turned on and the high-side MOS transistor 131 is turned off. Since a gate of the low-side MOS transistor 132 is grounded, a voltage of 0 V is outputted at an output point o, i.e., Vo=0 V. In this case, the output point outputs a pulse signal.

In the embodiments of the present disclosure, when a control logic module is used to control turn-on and turn-off of an MOS transistor, the MOS transistor may generate parasitic capacitance. When a control signal outputted by the control logic module (the high-side control logic module 111 and the low-side control logic module 112) has a relatively low frequency, for example, a frequency of 100 KHz and a period of 10 us, dead time may be set to 1.2 µs. When the high-side MOS transistor 131 is switched from a turn-on state to a turn-off state under the control of the high-side control logic module 111, the high-side MOS transistor 131 may be completely turned off during the dead time, and when the dead time lapses, the low-side MOS transistor can be turned on under the control of the low-side control logic module 121. Therefore, the parasitic capacitance generated by the high-side MOS transistor 131 cannot be transmitted to the low-side MOS transistor 132, without causing the crosstalk in the circuit.

When the control signal outputted by the control logic module (the high-side control logic module 111 and the low-side control logic module 112) has a relatively high frequency, for example, a frequency of 250 KHz and a period of 4 µs, if the dead time is set to be 1.2 µs, the high-side MOS transistor 131 or the low-side MOS transistor 132 can be only turned on of 0.8 µs in one period. That is, the turn-on time of the MOS transistor in one period is shorter than the dead time, thereby resulting in low efficiency. If the dead time is set to be 0.4 µs, during controlling the high-side MOS transistor 131 to be switched from a turn-on state to a turn-off state by the high-side control logic module 111, the low-side MOS transistor 132 is turned on before the high-side MOS transistor 131 is fully turned off within the dead time, such that the parasitic capacitance generated by the high-side MOS transistor 131 may be transmitted to the low-side MOS transistor 132, thereby causing crosstalk in the circuit.

In some embodiments, the high-side MOS transistor 131 and the low-side MOS transistor 132 can be isolated from each other by a transformer, a capacitor, or an optocoupler (also referred to as an optocoupler or an opto-isolator). Here, for a transformer 121 and a transformer 122, the transformer 121 may have a primary side connected to the high-side control logic module 111 and a secondary side connected to the high-side MOS transistor 131; and the transformer 122 may have a primary side connected to the low-side control logic module 112 and a secondary side connected to the low-side MOS transistor 132.

For a capacitor 121 and a capacitor 122, one end of the capacitor 121 may be connected to the high-side control logic module 111, and the other end thereof may be connected to the high-side MOS transistor 131; and one end of the transformer 122 may be connected to the low-side control logic module 112, and the other end thereof may be connected to the low-side MOS transistor 132.

For an optocoupler 121 and an optocoupler 122, one end of the optocoupler 121 may be connected to the high-side control logic module 111, and the other end thereof may be connected to the high-side MOS transistor 131; and one end of the optocoupler 122 may be connected to the low-side control logic module 112, and the other end thereof may be connected to the low-side MOS transistor 132. The optocoupler 121 and/or optocoupler 122 according to the embodiments of the present disclosure may include a light emitter and a light receiver.

However, when these isolation methods are adopted, position arrangements are limited. For example, for a transformer, a distance between a primary side and a secondary side of the transformer should not be too long, as a voltage transformation of the transformer is implemented based on the principle of electromagnetic induction. However, when the distance between the primary side and the secondary side of the transformer is relatively short, if an output of the high-side control logic module 111 is at a high level, the parasitic capacitance generated by the high-side MOS transistor 131 at a high frequency may be transmitted to the low-side MOS transistor 132, thereby causing the crosstalk in the circuit and leading to a mistaken turn-on of the low-side MOS transistor 132.

Similarly, for a capacitor, since a capacity of the capacitor is inversely proportional to a distance between two polar plates, the capacity of the capacitor decreases with an increase in the distance between the two polar plates, and it increases with a decrease in the distance between the two polar plates. Thus, the distance between the two polar plates of the capacitor should not be too long. However, when the distance between the two polar plates of the capacitor is relatively short, if an output of the high-side control logic module 111 is at a high level, the parasitic capacitance generated by the high-side MOS transistor 131 at a high frequency may be transmitted to the low-side MOS transistor 132, thereby causing the crosstalk in the circuit and leading to a mistaken turn-on of the low-side MOS transistor 132.

Similarly, for an optocoupler, since the optocoupler uses light as a medium to transmit electrical signals and transmission of light waves is distance-dependent, an energy loss increases with an increase in a transmission distance of the light waves, and it decreases with a decrease in the transmission distance of the light waves. Thus, a distance between a light emitter and a light receiver of the optocoupler should not be too long. However, when the distance between the light emitter and the light receiver of the optocoupler is relatively short, if an output of the high-side control logic module 111 is at a high level, the parasitic capacitance generated by the high-side MOS transistor 131 at a high frequency may be transmitted to the low-side MOS transistor 132, thereby causing the crosstalk in the circuit and leading to a mistaken turn-on of the low-side MOS transistor 132.

With the control circuit according to the embodiments of the present disclosure, the dead time of the control signal may be set to be relatively shorter at a high output frequency to improve efficiency without causing crosstalk in the circuit. In addition, when a microwave unit is used to control turn-on and turn-off of the switch transistor, a distance between a transmitting terminal and a receiving terminal of the microwave unit can be relatively long, which can further avoid the crosstalk in the circuit and prevent the switch transistor from being turned on mistakenly.

The control circuit according to the embodiments of the present disclosure is described in detail below in combination with FIG. 2.

As illustrated in FIG. 2, the control circuit according to the embodiments of the present disclosure includes a control unit 210 and a microwave unit 220.

The control unit 210 is configured to output a control signal.

The control unit according to the embodiments of the present disclosure is configured to output a control signal. The control signal may be a pulse signal having a period of 4 µs or 0.02 ns, which is not specifically limited in the present disclosure.

The microwave unit 220 has a transmitting terminal and a receiving terminal. The transmitting terminal is connected to the control unit. The receiving terminal is connected to at least one switch transistor. The transmitting terminal of the microwave unit 220 is configured to convert the control signal into a microwave signal and transmit the microwave signal to the receiving terminal. The receiving terminal of the microwave unit 220 is configured to convert the microwave signal into the control signal to control turn-on or turn-off of the at least one switch transistor 230.

According to the embodiments of the present disclosure, the transmitting terminal of the microwave unit 220 converts, after receiving the control signal outputted by the control unit 210, the control signal into the microwave signal and transmits the microwave signal to the receiving terminal of the microwave unit 220. The receiving terminal converts, after receiving the microwave signal, the microwave signal into the control signal. Thus, the converted control signal is used to control the turn-on and turn-off of the at least one switch transistor.

In some embodiments, the microwave unit includes an Integrated Circuit (IC) chip. The IC chip encapsulates an Extremely High Frequency (EHF) antenna.

The IC chip according to the embodiments of the present disclosure may encapsulate the EHF antenna, including a transmitting antenna and a receiving antenna, i.e., the transmitting terminal and the receiving terminal according to the embodiments of the present disclosure. Therefore, the microwave unit can achieve high-speed wireless data transmission (e.g., a transmission speed of up to 6 GB/s) based on a high carrier frequency (e.g., 60 GHz).

According to the embodiments of the present disclosure, it should be understood that, the transmitting terminal of the microwave unit 220 converts the control signal outputted by the control unit into the microwave signal, and the microwave signal can be transmitted in the vacuum at a speed equivalent to the speed of light without relying on any medium during transmission. Therefore, after the control signal is converted into the microwave signal by the transmitting terminal of the microwave unit 220, the microwave signal can be quickly transmitted to the receiving terminal of the microwave unit 220, and then the receiving terminal of the microwave unit 220 converts the microwave signal into the control signal, allowing the switch transistor to quickly respond thereto.

The switch transistor according to the embodiments of the present disclosure may be an Insulated Gate Bipolar Transistor (IGBT), an MOS transistor, or a triode, etc., which is not specifically limited in the present disclosure.

With the control circuit according to the embodiments of the present disclosure, in a process of transmitting the control signal, the transmitting terminal of the microwave unit converts the control signal into the microwave signal and transmits the microwave signal to the receiving terminal of the microwave unit, and the receiving terminal converts the microwave signal into the control signal after receiving the microwave signal, such that the switch transistor can be turned on or off under to control of the converted control signal. On the one hand, due to a high response speed of the microwave unit, the transmitting terminal of the microwave unit can convert the control signal into the microwave signal and quickly transmit the microwave signal to the receiving terminal. Therefore, even if the dead time of the control signal is set to be short, the switch transistor can be turned on or off quickly without causing crosstalk in the circuit. On the other hand, since the microwaves can be transmitted without depending upon any medium, a distance between the transmitting terminal and the receiving terminal of the microwave unit can be relatively long, thereby further avoiding the crosstalk in the circuit and preventing the switch transistor from being mistakenly turned on.

As described above, according to the embodiments of the present disclosure, the transmitting terminal of the microwave unit converts the control signal into the microwave signal and transmits the microwave signal to the receiving terminal, and the receiving terminal of the microwave unit converts the microwave signal into the control signal to control the turn-on or turn-off of the switch transistor. In addition, according to the embodiments of the present disclosure, the microwave unit is further configured to isolate parasitic capacitance generated by the switch transistor. Detailed description in this regard will be made below.

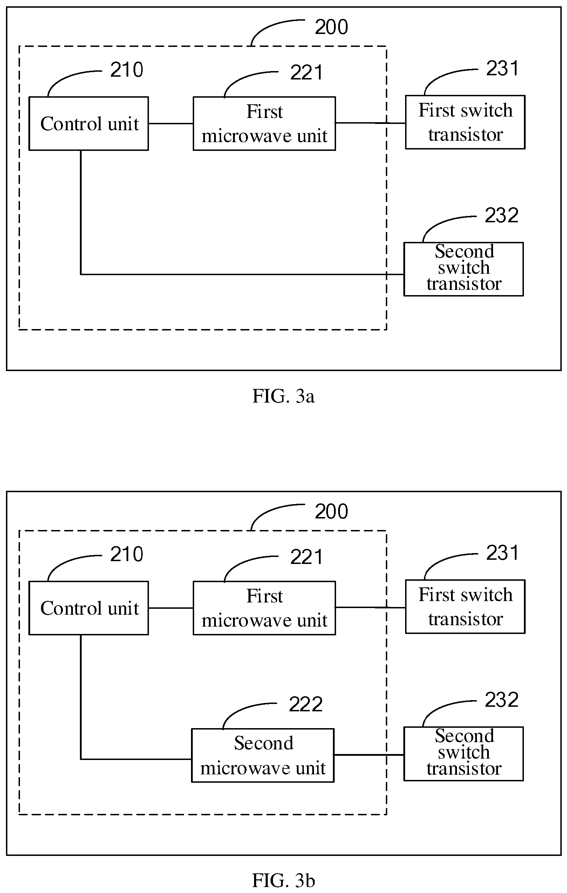

In some embodiments, referring to FIG. 3a, a structural schematic diagram of a control circuit according to another embodiment of the present disclosure is illustrated.

As illustrated in FIG. 3a, the at least one switch transistor 230 includes a first switch transistor 231 and a second switch transistor 232. The first switch transistor 231 is connected to a first microwave unit 221, and the second switch transistor 232 is connected to the control unit 210.

The microwave unit includes the first microwave unit 221 connected to the control unit 210 and the first switch transistor 231. The first microwave unit 221 is configured to transmit the control signal to control turn-on or turn-off of the first switch transistor 231 and configured to isolate parasitic capacitance generated by the first switch transistor 231.

In the embodiments of the present disclosure, the control unit 210 outputs the control signal, and transmits the signal to the first switch transistor 231 via the first microwave unit 221 to control the turn-on or turn-off of the first switch transistor 231.

In the embodiments of the present disclosure, in a process of controlling the turn-on or turn-off of the first switch transistor 231, the first microwave unit 221 also isolates transmission of the parasitic capacitance generated by the first switch transistor 231 to the second switch transistor 232, in order to avoid the crosstalk in the circuit.

In such an implementation, a signal outputted by the control unit 210 may be used to control the turn-on or turn-off of the second switch transistor 232.

In some embodiments, referring to FIG. 3b, a structural schematic diagram of a control circuit according to yet another embodiment of the present disclosure is illustrated.

As illustrated in FIG. 3b, the at least one switch transistor 230 includes a first switch transistor 231 and a second switch transistor 232. The microwave unit includes a first microwave unit 221 connected to the control unit 210 and the first switch transistor 231, and a second microwave unit 222 connected to the control unit 210 and the second switch transistor 232. The first microwave unit 221 is configured to transmit the control signal to control turn-on or turn-off of the first switch transistor 231 and also configured to isolate parasitic capacitance generated by the first switch transistor 231. The second microwave unit 222 is configured to transmit the control signal to control turn-on or turn-off of the second switch transistor 232 and also configured to isolate parasitic capacitance generated by the second switch transistor 232.

According to the embodiments of the present disclosure, the control unit 210 outputs the control signal, and transmits the signal to the first switch transistor 231 via the first microwave unit 221 to control the turn-on or turn-off of the first switch transistor 231; and the control unit 210 can also output the control signal, and transmit the signal to the second switch transistor 232 via the second microwave unit 222 to control the turn-on or turn-off of the second switch transistor 232.

According to the embodiments of the present disclosure, in a process of controlling the turn-on or turn-off of the first switch transistor 231, the first microwave unit 221 also isolates the transmission of the parasitic capacitance generated by the first switch transistor 231 to the second switch transistor 232, thereby avoiding the crosstalk in the circuit; and in a process of controlling the turn-on or turn-off of the second switch transistor 232, the second microwave unit 222 can also isolate the transmission of the parasitic capacitance generated by the second switch transistor 232 to the first switch transistor 231, thereby avoiding the crosstalk in the circuit.

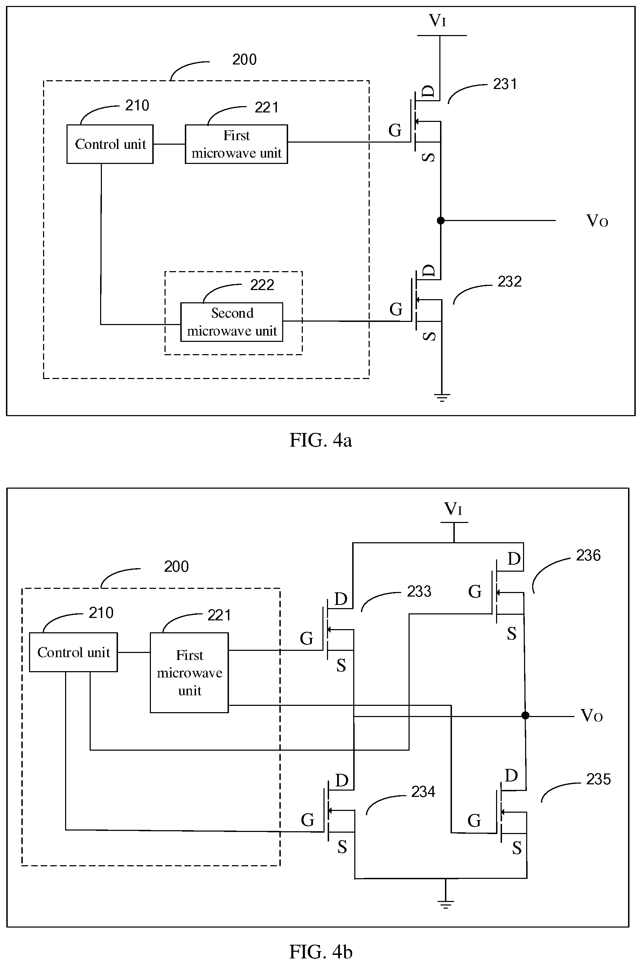

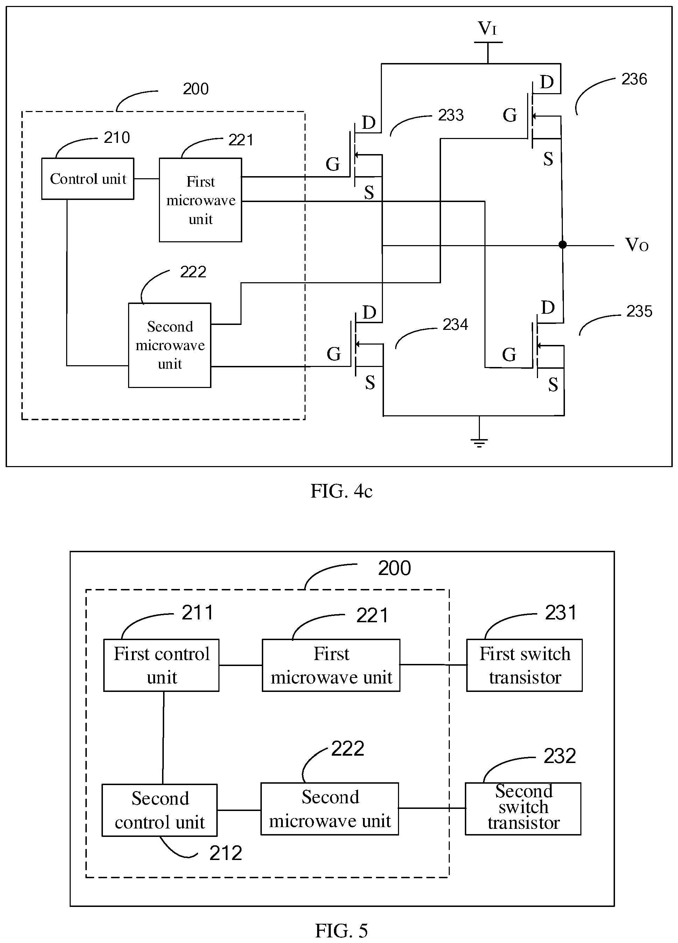

The following description is made by taking the switch transistor being a MOS transistor as an example. FIG. 4a, FIG. 4b, and FIG. 4c each are a structural schematic diagram of a control circuit according to an embodiment of the present disclosure.

According to the embodiments of the present disclosure, the control circuit may control a half-bridge circuit or a full-bridge circuit, which is not specifically limited in the present disclosure. It will be explained separately below.

As illustrated in FIG. 4a, the control circuit according to this embodiment of the present disclosure may control a half-bridge circuit. In the embodiment of the present disclosure, the half-bridge circuit may include an N-channel MOS transistor 231 and an N-channel MOS transistor 232. In a case that the control unit 210 outputs a high-level signal, if a pin connected to the MOS transistor 231 is disconnected therefrom, the transmitting terminal of the first microwave unit 221 converts the high-level signal into a microwave signal and transmits the microwave signal to the receiving terminal of the first microwave unit 221. After receiving the microwave signal, the receiving terminal converts the microwave signal into a control signal and transmit the control signal to the N-channel MOS transistor 231. In this case, since a gate voltage of the N-channel MOS transistor 231 is higher than a source voltage, the N-channel MOS transistor 231 can be turned on.

In the case that the control unit 210 outputs the high-level signal, if a pin connected to the MOS transistor 232 is disconnected therefrom, the transmitting terminal of the first microwave unit 221 can convert the high-level signal into a microwave signal and transmit the microwave signal to the receiving terminal of the second microwave unit 222. After receiving the microwave signal, the receiving terminal can convert the microwave signal into a control signal and transmit the control signal to the N-channel MOS transistor 232. In this case, since a gate voltage of the N-channel MOS transistor 232 is higher than a source voltage, the N-channel MOS transistor 232 can be turned on.

According to the embodiments of the present disclosure, on the one hand, due to a high transmission speed of microwaves, even at a high frequency, e.g., at a frequency of 250KHz, i.e., a period of 4 µs, the dead time of the control signal can still be short. Assuming that the dead time is 0.4µs, the transmitting terminal of the first microwave unit 221 can convert a signal outputted by the control unit 210 into a microwave signal and quickly output the microwave signal to the receiving terminal of the first microwave unit 221 within the 0.4µs, and then the receiving terminal of the first microwave unit 221, once receiving the microwave signal, converts the microwave signal into the control signal and outputs the control signal to the MOS transistor 231; or the transmitting terminal of the second microwave unit 222 can convert a signal outputted by the control unit 210 into a microwave signal and quickly output the microwave signal to the receiving terminal of the second microwave unit 222 within 0.4 µs, and then the receiving terminal of the second microwave unit 222, once receiving the microwave signal, can convert the microwave signal into the control signal and output the control signal to the MOS transistor 232. In addition, the control unit 210 can be turned on in half a period for 1.6 µs, which is longer than the dead time of 0.4 µs, and thus the transmission efficiency can be improved.

On the other hand, the microwave unit is different from transformers, capacitors, and optocouplers in that the microwaves can be transmitted without requiring any medium and can pass through an object almost without being absorbed. Therefore, the distance between the transmitting terminal and the receiving terminal of the microwave unit can be relatively long, e.g., 1.5 cm or 2 cm, etc.

As for transformers, capacitors, and optocouplers, based on the principle of electromagnetic induction of transformers, charge movement is the basis for the working of capacitors, and transmission of light waves, as electromagnetic waves of a specific frequency band, depends upon the distance. In these transmission methods, the distance between the transmitting terminal and the receiving terminal should be smaller than a certain threshold to transmit the signals to the switch transistor.

However, according to the embodiments of the present disclosure, the distance between the transmitting terminal and the receiving terminal of each of the first microwave unit 221 and the second microwave unit 222 may be relatively long, e.g., 1.5 cm or 2 cm, as mentioned above. Further, the parasitic capacitance generated by the MOS transistor 231 or the MOS transistor 232 are isolated to avoid the crosstalk in the circuit.

That is, when the MOS transistor 231 is turned on, the parasitic capacitance generated by the MOS transistor 231 is not transmitted to the MOS transistor 232 due to the long distance between the transmitting terminal and the receiving terminal of the microwave unit; and when the MOS transistor 232 is turned on, the parasitic capacitance generated by the MOS transistor 232 is also not transmitted to the MOS transistor 231 due to the long distance between the transmitting terminal and the receiving terminal of the microwave unit.

According to the embodiments of the present disclosure, the parasitic capacitance may also be referred to as stray capacitance, which is a capacitive characteristic exhibited by the switch transistor at high frequencies.

In some embodiments, the second microwave unit 222 may be absent. That is, the control signal outputted by the control unit 210 may be used directly to control the turn-on or turn-off of the MOS transistor 232.

The case that the control circuit controls the half-bridge circuit according to the embodiments of the present disclosure is described above. The case that the control circuit controls the full-bridge circuit according to the embodiments of the present disclosure will be described below.

In some embodiments, the at least one switch transistor includes a third switch transistor, a fourth switch transistor, a fifth switch transistor, and a sixth switch transistor. The third switch transistor is connected to a first microwave unit. The fourth switch transistor is connected to the control unit. The microwave unit includes a first microwave unit connected to the control unit and the third switch transistor. The first microwave unit is configured to transmit the control signal to control turn-on or turn-off of the third switch transistor and/or the fifth switch transistor and configured to isolate parasitic capacitance generated by the third switch transistor and/or the fifth switch transistor.

FIG. 4b is a structural schematic diagram of a control circuit according to an embodiment of the present disclosure. According to this embodiment of the present disclosure, the control circuit may control a full-bridge circuit. As illustrated in FIG. 4b, according to this embodiment of the present disclosure, the full-bridge circuit includes an MOS transistor 233, an MOS transistor 234, an MOS transistor 235, and an MOS transistor 236. Here, the third switch transistor may be an N-channel MOS transistor 233, the fourth switch transistor may be an N-channel MOS transistor 234, the fifth switch transistor may be an N-channel MOS transistor 235, and the sixth switch transistor may be an N-channel MOS transistor 236.

According to the embodiments of the present disclosure, in a case that the control unit 210 outputs a high-level signal, if pins connected to the N-channel MOS transistor 233 and the N-channel MOS transistor 235 are disconnected therefrom, the transmitting terminal of the first microwave unit 221 converts the high-level signal into a microwave signal and transmits the microwave signal to the receiving terminal of the first microwave unit 221. After receiving the microwave signal, the receiving terminal of the first microwave unit 221 converts the microwave signal into a control signal and transmits the control signal to the N-channel MOS transistor 233 and the N-channel MOS transistor 235. In this case, a gate voltage of the N-channel MOS transistor 233 is higher than a source voltage of the N-channel MOS transistor 233 and a gate voltage of the N-channel MOS transistor 235 is higher than a source voltage of the N-channel MOS transistor 235. Thus, when the control unit outputs the high-level signal and the pins of the N-channel MOS transistor 233 and the N-channel MOS transistor 235 are disconnected, the N-channel MOS transistor 233 and the N-channel MOS transistor 235 can be turned on.

According to the embodiments of the present disclosure, the first microwave unit 221 isolates parasitic capacitance generated by the N-channel MOS transistor 233 and the N-channel MOS transistor 235. The first microwave unit 221 isolates the transmission of the parasitic capacitance generated by the N-channel MOS transistor 233 and the N-channel MOS transistor 235 to the N-channel MOS transistor 234 and/or the N-channel MOS transistor 236.

In a case that the control unit 210 outputs a high-level signal, if pins connected to the N-channel MOS transistor 234 and the N-channel MOS transistor 236 are disconnected therefrom, a control signal outputted by the control unit 210 is transmitted to the N-channel MOS transistor 234 and the N-channel MOS transistor 236. In this case, since a gate voltage of the N-channel MOS transistor 234 is higher than a source voltage of the N-channel MOS transistor 234 and a gate voltage of the N-channel MOS transistor 236 is higher than a source voltage of the N-channel MOS transistor 236, the N-channel MOS transistor 234 and the N-channel MOS transistor 236 can be turned on. Therefore, when the control unit outputs the high-level signal and the pins of the N-channel MOS transistor 234 and the N-channel MOS transistor 236 are disconnected, the N-channel MOS transistor 234 and the N-channel MOS transistor 236 can be turned on.

In some embodiments, the at least one switch transistor includes a third switch transistor, a fourth switch transistor, a fifth switch transistor, and a sixth switch transistor.

The microwave unit includes a first microwave unit connected to the control unit and the third switch transistor, and a second microwave unit connected to the control unit and the fourth switch transistor. The first microwave unit is configured to transmit the control signal to control turn-on or turn-off of the third switch transistor and/or the fifth switch transistor and configured to isolate parasitic capacitance generated by the third switch transistor and/or the fifth switch transistor. The second microwave unit is configured to transmit the control signal to control turn-on or turn-off of the fourth switch transistor and/or the sixth switch transistor and configured to isolate transmission of parasitic capacitance generated by the fourth switch transistor and/or the sixth switch transistor to the third switch transistor and/or the fifth switch transistor.

FIG. 4c is a structural schematic diagram of a control circuit according to an embodiment of the present disclosure. According to this embodiment of the present disclosure, the control circuit may also control a full-bridge circuit. As illustrated in FIG. 4c, according to this embodiment of the present disclosure, the full-bridge circuit includes a MOS transistor 233, a MOS transistor 234, a MOS transistor 235, and a MOS transistor 236. Here, the third switch transistor may be a N-channel MOS transistor 233, the fourth switch transistor may be a N-channel MOS transistor 234, the fifth switch transistor may be a N-channel MOS transistor 235, and the sixth switch transistor may be a N-channel MOS transistor 236.

According to the embodiments of the present disclosure, in a case that the control unit 210 outputs a high-level signal, if pins connected to the N-channel MOS transistor 233 and the N-channel MOS transistor 235 are disconnected therefrom, the transmitting terminal of the first microwave unit 221 converts the high-level signal into a microwave signal and transmits the microwave signal to the receiving terminal of the first microwave unit 221. After receiving the microwave signal, the receiving terminal of the first microwave unit 221 converts the microwave signal into a control signal and transmit the control signal to the N-channel MOS transistor 233 and the N-channel MOS transistor 235. In this case, since a gate voltage of the N-channel MOS transistor 233 is higher than a source voltage of the N-channel MOS transistor 233 and a gate voltage of the N-channel MOS transistor 235 is higher than a source voltage of the N-channel MOS transistor 235, the N-channel MOS transistor 233 and the N-channel MOS transistor 235 can be turned on.

In a case that the control unit 210 outputs a high-level signal, if pins connected to the N-channel MOS transistor 234 and the N-channel MOS transistor 236 are disconnected therefrom, the transmitting terminal of the second microwave unit 222 can convert the high-level signal into a microwave signal and transmit the microwave signal to the receiving terminal of the second microwave unit 222. After receiving the microwave signal, the receiving terminal of the second microwave unit 222 can convert the microwave signal into a control signal and transmit the control signal to the N-channel MOS transistor 234 and the N-channel MOS transistor 236. In this case, since a gate voltage of the N-channel MOS transistor 234 is higher than a source voltage of the N-channel MOS transistor 234 and a gate voltage of the N-channel MOS transistor 236 is higher than a source voltage of the N-channel MOS transistor 236, the N-channel MOS transistor 234 and the N-channel MOS transistor 236 can be turned on.

According to the embodiments of the present disclosure, the first microwave unit 221 isolates parasitic capacitance generated by the N-channel MOS transistor 233 and the N-channel MOS transistor 235. The first microwave unit 221 isolates transmission of the parasitic capacitance generated by the N-channel MOS transistor 233 and the N-channel MOS transistor 235 to the N-channel MOS transistor 234 and/or the N-channel MOS transistor 236.

According to the embodiments of the present disclosure, the second microwave unit 222 can isolate parasitic capacitance generated by the N-channel MOS transistor 234 and/or the N-channel MOS transistor 236. For example, the second microwave unit 222 can isolate the transmission of the parasitic capacitance generated by the N-channel MOS transistor 234 and/or the N-channel MOS transistor 236 to the N-channel MOS transistor 233 and the N-channel MOS transistor 235.

It should be understood that, the full-bridge circuit diagram according to the embodiments of the present disclosure is not limited to those illustrated in FIG. 4b and/or FIG. 4c, and may also be in other forms. The present disclosure is not limited in this regard.

In some embodiments, the control circuit 200 may further include a first isolation unit and a second isolation unit.

The first isolation unit is configured to isolate transmission of parasitic capacitance generated by the first switch transistor 231 to the second switch transistor 232. The second isolation unit is configured to isolate transmission of parasitic capacitance generated by the second switch transistor 232 to the first switch transistor 231. Here, the first isolation unit has one end connected to the first microwave unit 221 and another end connected to the first switch transistor 231; and the second isolation unit has one end connected to the second microwave unit 222 and another end connected to the second switch transistor 232.

In some embodiments, the control circuit 200 may further include a first isolation unit and a second isolation unit.

The first isolation unit is configured to isolate transmission of parasitic capacitance generated by a third switch transistor 233 and/or a fifth switch transistor 235 to a fourth switch transistor 234 and/or a sixth switch transistor 236. The second isolation unit is configured to isolate transmission of parasitic capacitance generated by the fourth switch transistor 234 and/or the sixth switch transistor 236 to the third switch transistor 233 and/or the fifth switch transistor 235. Here, the first isolation unit has one end connected to the first microwave unit 221 and another end to the third switch transistor 233; and the second isolation unit has one end connected to the second microwave unit 222 and another end connected to the fourth switch transistor 234.

According to the embodiments of the present disclosure, the first isolation unit may be configured to isolate transmission of parasitic capacitance, which is generated by the first switch transistor 231 at a high frequency, to the second switch transistor 232; and the second isolation unit may be configured to isolate transmission of parasitic capacitance, which is generated by the second switch transistor 232 at a high frequency, to the first switch transistor 231, thereby further avoiding the crosstalk in the circuit.

Alternatively, the first isolation unit may be configured to isolate transmission of parasitic capacitance, which is generated by the third switch transistor 233 and/or the fifth switch transistor 235 at a high frequency, to the fourth switch transistor 234 and/or the sixth switch transistor 236; and the second isolation unit may be configured to isolate transmission of parasitic capacitance, which is generated by the fourth switch transistor 234 and/or the sixth switch transistor 236 at a high frequency, to the third switch transistor 233 and/or the fifth switch transistor 235, thereby further avoiding the crosstalk in the circuit.

According to the embodiments of the present disclosure, for example, as illustrated in FIG. 4a, due to the high transmission speed of microwaves, a distance between the transmitting terminal and the receiving terminal of the first microwave unit 221 may be relatively long. For example, the distance may be greater than a first threshold. Therefore, the first microwave unit 221 per se can isolate the transmission of the parasitic capacitance generated by the first switch transistor 231 to the second switch transistor 232, and the first isolation unit may be provided to further isolate the transmission of the parasitic capacitance generated by the first switch transistor 231 to the second switch transistor 232.

Similarly, a distance between the transmitting terminal and the receiving terminal of the second microwave unit 222 may be relatively long. For example, the distance may be greater than the first threshold. Therefore, the second microwave unit 222 per se can isolate the transmission of the parasitic capacitance generated by the second switch transistor 232 to the first switch transistor 231, and the second isolation unit may be provided to further isolate the transmission of the parasitic capacitance generated by the second switch transistor 232 to the first switch transistor 231.

It should be understood that, according to the embodiments of the present disclosure, the distance between the transmitting terminal and the receiving terminal of the first microwave unit 221 as well as the distance between the transmitting terminal and the receiving terminal of the second microwave unit 222 may be the same or different, which is not specifically limited in the present disclosure.

In some embodiments, as illustrated in FIG. 5, the control unit 210 includes a first control unit 211 connected to the first microwave unit 221, and a second control unit 212 connected to the second microwave unit 222. The first control unit 211 is configured to output a first control signal to the first microwave unit 221 and configured to control output time of the first control signal. The second control unit 212 is configured to output a second control signal to the second microwave unit 222 and configured to control output time of the second control signal.

According to the embodiments of the present disclosure, the first microwave unit 221 and the second microwave unit 222 also control transmission of control signals via two control units, respectively. For example, the first control unit 211 may be configured to transmit the first control signal to the first microwave unit 221. The transmitting terminal of the first microwave unit 221 can convert, based on the first control signal transmitted by the first control unit 211, the first control signal into a first microwave signal, and transmit the first microwave signal to the receiving terminal of the first microwave unit 221. After receiving the first microwave signal, the receiving terminal of the first microwave unit 221 converts the first microwave signal into the first control signal, and transmits the first control signal to the first switch transistor 231 to control turn-on or turn-off of the first switch transistor 231. The second control unit 212 may be configured to transmit the second control signal to the second microwave unit 222. The transmitting terminal of the second microwave unit 222 can convert, based on the second control signal transmitted by the second control unit 212, the second control signal into a second microwave signal, and transmit the second microwave signal to the receiving terminal of the second microwave unit 222. After receiving the second microwave signal, the receiving terminal of the second microwave unit 222 can convert the second microwave signal into the second control signal, and transmit the second control signal to the second switch transistor 232 to control turn-on or turn-off of the second switch transistor 232.

It should be noted that the first control unit 211 and the second control unit 212 may communicate with each other. In this way, the first control unit 211 and the second control unit 212 may output control signals more accurately.

In some embodiments, when the at least one switch transistor includes the first switch transistor and the second switch transistor, an output of a high level and/or a low level of the first control signal are at a time point different from that of an output of a high level and/or a low level of the second control signal, and the second switch transistor is turned on when the first switch transistor is completely turned off; or when the at least one switch transistor includes the third switch transistor, the fourth switch transistor, the fifth switch transistor, and the sixth switch transistor, an output of a high level and/or a low level of the first control signal is at a time point different from that of an output of a high level and/or a low level of the second control signal, and the fourth switch transistor and the sixth switch transistor are turned on when the third switch transistor and the fifth switch transistor are completely turned off.

In some embodiments, the first control unit is further configured to transmit a first synchronization signal to the second control unit, and/or configured to receive a second synchronization signal transmitted by the second control unit; and the second control unit is further configured to transmit the second synchronization signal to the first control unit, and/or configured to receive the first synchronization signal transmitted by the first control unit.

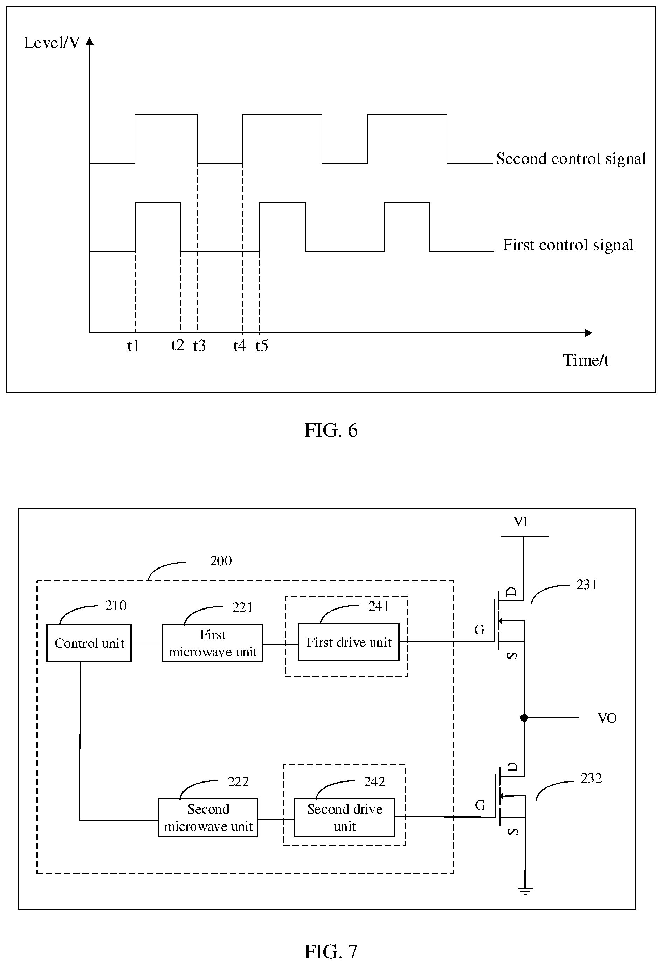

In combination with FIG. 6, description is made by taking a half-bridge circuit as an example. In a time period (t1-t2), the first control unit 211 can output a high level to control the first switch transistor 231 to be in a turn-on state. At a time point t2, the first control unit 221 can output a low level to control the first switch transistor 231 to be in a turn-off state. As can be seen from FIG. 6, when the first control unit 211 outputs a low level at the time point t2, the second control unit 212, instead of outputting a low level instantaneously, starts to output a low level at a time point t3 to control turn-on of the second switch transistor 232.

As illustrated, a time period (t2-t3) is referred to as dead time. Within the dead time, the first control unit 211 can output a low level and the second control unit 212 can output a high level, in order to control the second switch transistor 232 to be turned on only when the first switch transistor 231 is completely turned off, thereby avoiding the crosstalk in the circuit, which may occur in a situation that the first switch transistor 231 is not completely turned off when the second switch transistor 232 is turned on.

According to the embodiments of the present disclosure, the first control unit 211 and the second control unit 212 may communicate with each other. For example, the first control unit 211 may be configured to notify the second control unit 212 to end an output of the high level at the time point t2 and start an output of the low level. The second control unit 212, after receiving the notification from the first control unit 211, can start to output the low level after the predetermined dead time, i.e., the second control unit 212 can output the low level at the time point t3, thereby avoiding the crosstalk in the circuit, which may occur in a situation that the first switch transistor 231 is not completely turned off when the second control unit 212 outputs the low level to control the second switch transistor 232 to be turned on.

Alternatively, the first control unit 211 ends the output of the high level at the time point t2, and notifies, at any time point within the dead time (t2-t3), the second control unit 212 to output the low level at the time point t3. The second control unit 212 can output, after receiving the notification from the first control unit 211, the low level at the time point t3, thereby avoiding the crosstalk in the circuit, which may occur in a situation that the first switch transistor 231 is not completely turned off when the second control unit 212 outputs the low level to control the second switch transistor 232 to be turned on.

According to the embodiments of the present disclosure, the first control unit 211 may be further configured to receive a synchronization signal transmitted by the second control unit 212, to determine the time point of the output of the high level and/or the low level.

Regarding the full-bridge circuit, the time point of the output of the high or low level of the control signal is similar to that of the half-bridge circuit, and the details thereof will be omitted here for simplicity.

In some embodiments, the signals outputted by the first control unit 211 or the second control unit 212 may be incapable of controlling the turn-on or turn-off of the first switch transistor 231 or the second switch transistor 232. Therefore, the turn-on or turn-off of the switch transistor may be controlled with the help of a drive unit.

According to the embodiments of the present disclosure, the control circuit 200 may also include a first drive unit 241 and a second drive unit 242, as illustrated in FIG. 7.

The first drive unit 241 may be configured to amplify the control signal outputted by the first microwave unit 211, such that the amplified signal is capable of controlling the turn-on or turn-off of the first switch transistor 231; and the second drive unit 242 may be configured to amplify the control signal outputted by the second microwave unit 222, such that the amplified signal is capable of controlling the turn-on or turn-off of the second switch transistor 232.

It should be understood that, according to the embodiments of the present disclosure, the first drive unit 241 and/or the second drive unit 242 may be configured to amplify the control signal outputted by the control unit 210, i.e., to strengthen a control capability of the control signal, such that the control unit 210 may be capable of controlling the switch transistor.

According to the embodiments of the present disclosure, the drive unit may be a charge pump bootstrap control circuit, a control chip, etc.

It should be understood that, according to the embodiments of the present disclosure, at least one drive unit may also be included in FIG. 2 to FIG. 5. For example, as illustrated in FIG. 2, the drive unit may be located between the microwave unit 220 and the at least one switch transistor 230 to amplify the control signal outputted by the microwave unit 220, such that the microwave unit 220 can control the at least one switch transistor 230.

As illustrated in FIG. 3a, two drive units may be provided. One of the two drive units may be located between the first microwave unit 221 and the first switch transistor 231 to amplify the control signal outputted by the first microwave unit 221, such that the first microwave unit 221 can control the first switch transistor 231. The other one of the two drive units may be located between the control unit 210 and the second switch transistor 232 to amplify the control signal outputted by the control unit 21, such that the control unit 21 can control the second switch transistor 232.

As illustrated in FIG. 4b, two drive units may be provided. One of the two drive units may be located between the first microwave unit 221 and the switch transistor 233 to amplify the control signal outputted by the first microwave unit 221, such that the first microwave unit 221 can control the switch transistor 233. The other of the two drive units may be located between the control unit 210 and the switch transistor 234 to amplify the control signal outputted by the control unit 210, such that the control unit 210 can control the switch transistor 234.

As illustrated in each of FIG. 3b, FIG. 4a, and FIG. 5, two drive units may be provided. One of the two drive units may be located between the first microwave unit 221 and the first switch transistor 231 to amplify the control signal outputted by the first microwave unit 221, such that the first microwave unit 221 can control the first switch transistor 231. The other of the two drive units may be located between the second microwave unit 222 and the second switch transistor 232 to amplify the control signal outputted by the second microwave unit 222, such that the second microwave unit 222 can control the second switch transistor 232.

As illustrated in FIG. 4c, two drive units may be provided. One of the two drive units may be located between the first microwave unit 221 and the switch transistor 233 to amplify the control signal outputted by the first microwave unit 221, such that the first microwave unit 221 can control the switch transistor 233. The other of the two drive units may be located between the second microwave unit 222 and the switch transistor 234 to amplify the control signal outputted by the second microwave unit 222, such that the second microwave unit 222 can control the switch transistor 234.

In some embodiments, the dead time of the control signal is smaller than the first threshold.

Specifically, description is made below with reference to FIG. 5 and FIG. 6. As illustrated in FIG. 5, the first control unit 211 outputs a high level to control the first switch transistor 231 to be in the turn-on state. At the time point t2, the first control unit 221 can output a low level to control the first switch transistor 231 to be in the turn-off state. Referring to FIG. 6, the first control unit 211 can output a high level in the time period (t1-t2) to control the first switch transistor 231 to be in the turn-on state, and it can output a low level at the time point t2 to control turn-off of the first switch transistor 231. In addition, when the first control unit 211 outputs the low level at the time point t2, the second control unit 212, instead of outputting a low level instantaneously, starts to output a low level at the time point t3 to control the turn-on of the second switch transistor 232.

Similarly, the second control unit 212 may be configured to output a low level during a time period (t3-t4) to allow the second switch transistor 232 to be turned on. In this case, the first switch transistor is in the turn-off state. At a time point t4, the second control unit 212 may be configured to output a high level to start controlling the turn-off of the second switch transistor 232. When the second control unit 212 outputs a high level, the first control unit 211, instead of outputting a high level instantaneously, starts to output a high level at a time point t5 to start controlling turn-on of the first switch transistor 231.

Here, the time period (t2-t3) is referred to as the dead time. According to the embodiments of the present disclosure, the microwave unit can transmit signals to the switch transistor, and the transmitting terminal of the microwave unit can convert a control signal into a microwave signal and transmit the microwave signal to the receiving terminal of the microwave unit. In addition, since microwaves have a characteristic of fast transmission, the microwave signal can be quickly transmitted to the receiving terminal of the microwave unit. After the receiving terminal of the microwave unit converts the microwave signal into the control signal, the switch transistor can be turned on or off quickly. Therefore, a duration of the dead time may be set to be shorter than the first threshold. When the first threshold is 0.4 µs, the dead time according to the embodiments of the present disclosure may be 0.2 µs or 0.3 us, etc., which is not specifically limited in the present disclosure.

In some embodiments, a predetermined frequency of the control signal is greater than a second threshold.

According to the embodiments of the present disclosure, the predetermined frequency of the control signal may be greater than the second threshold. For example, when the second threshold is 200 KHz, it can be assumed that the predetermined frequency of the control signal is 250 KHz, i.e., a sum of turn-on time and a turn-off time of the two switch transistors may be 4 µs. Description is made below with reference to FIG. 5 and FIG. 6. The first control unit 211 can output a high level in the time period (t1-t2). When the dead time is 0.4 µs, the time period (t1-t2) illustrated in the figure is 1.6 µs and the time period (t2-t3) illustrated in the figure is 0.4 µs. Therefore, the turn-on time of the first switch transistor 231 in one period is 1.6 µs. The first control unit 211 may be configured to output a low level in the dead time (t2-t3) of 0.4 µs to completely turn off the first switch transistor 231. After the first switch transistor 231 is completely turned off, the second control unit 212 can start to output a low level to turn on the second switch transistor 232.

It should be understood that, when the second control unit 212 outputs a low level in the time period (t3-t4), the first control unit 211 can output a low level to switch the first switch transistor 231 to the turn-off state, thereby avoiding the crosstalk in the circuit, which may occur when the first switch transistor 231 is mistakenly turned on.

Similarly, in the embodiments of the present disclosure, when the predetermined frequency is 50 GHz, the period is 20 ps. With reference to FIG. 5 and FIG. 6, the first control unit 211 can output a high level in the time period (t1-t2). When the dead time is 4 ps, the time period (t1-t2) illustrated in the figure is 16 ps, and the time period (t2-t3) illustrated in the figure is 4 ps. Therefore, the turn-on time of the first switch transistor 231 in one period is 16 ps. The first control unit 211 can output a low level within the dead time (t2-t3) of 4 ps to completely turn off the first switch transistor 231. After the first switch transistor 231 is turned off completely, the second control unit 212 can output a low level to turn on the second switch transistor 232.

It should be understood that the above values are provided as examples, and other values may be set. For example, according to the embodiments of the present disclosure, the predetermined frequency may be 60 GHz, etc., which is not specifically limited in the present disclosure.

It should also be understood that, according to the embodiments of the present disclosure, a period of a signal outputted by the control unit decreases with an increase in the predetermined frequency. Thus, even if the dead time is set to be a small value, the microwave unit according to any of the embodiments of the present disclosure can quickly transmit a signal to the switch transistor, thereby turning on or off the switch transistor quickly. In addition, the parasitic capacitance become more significant as the frequency increases. Due to the relatively long distance between the transmitting terminal and the receiving terminal of the microwave unit, the parasitic capacitance generated by the switch transistor cannot be transmitted to other elements even at high frequencies, thereby avoiding the crosstalk in the circuit.

As mentioned above, the distance between the transmitting terminal and the receiving terminal of the microwave unit can be relatively long. Detailed description will be made below.

In some embodiments, the distance between the transmitting terminal of the microwave unit and the receiving terminal of the microwave unit is greater than a third threshold.

According to the embodiments of the present disclosure, the distance between the transmitting terminal and the receiving terminal of the microwave unit may be greater than the third threshold. For example, when the third threshold is 1 cm, the distance between the receiving terminal and the transmitting terminal of the microwave unit may be 1.5 cm, or 2 cm, etc., which is not limited in the present disclosure.

It should be understood that, since the microwaves can be transmitted independent of any medium, the microwaves have a high transmission speed, thereby shortening time for signal transmission. For the microwave unit, the transmitting terminal of the microwave unit is configured to convert the control signal into the microwave signal and quickly transmits the microwave signal to the receiving terminal of the microwave unit. The receiving terminal of the microwave unit converts the microwave signal into the control signal after receiving the microwave signal, allowing the switch transistor to respond quickly. That is, the switch transistor can be quickly turned on or turned off.

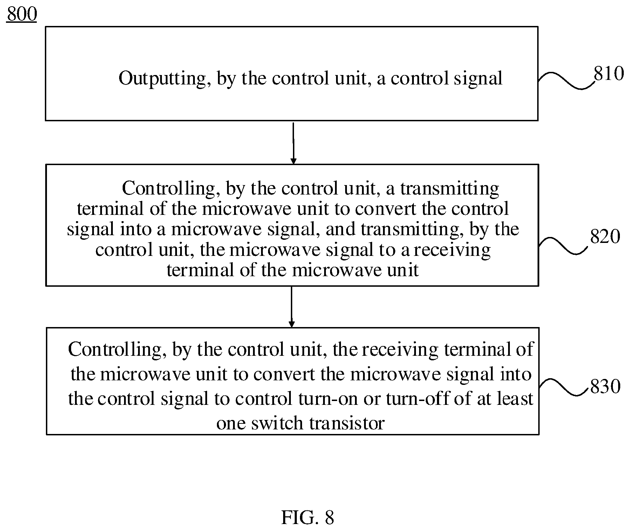

The apparatus embodiments of the present disclosure have been described in detail above with reference to FIG. 1 to FIG. 7, and method embodiments of the present disclosure will be described below with reference to FIG. 8. The method embodiments correspond to the apparatus embodiments, and thus for contents that are not elaborated, reference may be made to the above apparatus embodiments.

FIG. 8 illustrates a control method 800 for a switch transistor according to an embodiment of the present disclosure. As illustrated in FIG. 8, the method 800 may be applied in a control circuit including a control unit and a microwave unit. The method 800 includes actions at blocks 810 to 830.

At block 810, the control unit outputs a control signal.

At block 820, the control unit controls a transmitting terminal of the microwave unit to convert the control signal into a microwave signal, and transmits the microwave signal to a receiving terminal of the microwave unit.

At block 830, the control unit controls the receiving terminal of the microwave unit to convert the microwave signal into the control signal to control turn-on or turn-off of at least one switch transistor.

In some embodiments, the at least one switch transistor includes a first switch transistor connected to a first microwave unit and a second switch transistor connected to the control unit. The action of controlling, by the control unit, the transmitting terminal of the microwave unit to convert the control signal into the microwave signal and transmit the microwave signal to the receiving terminal of the microwave unit includes: controlling, by the control unit, a transmitting terminal of the first microwave unit to convert the control signal into a first microwave signal and transmit the first microwave signal to a receiving terminal of the first microwave signal. The action of controlling, by the control unit, the receiving terminal of the microwave unit to convert the microwave signal into the control signal to control the turn-on or the turn-off of the at least one switch transistor includes: controlling, by the control unit, the receiving terminal of the first microwave unit to convert the first microwave signal into the control signal to control turn-on or turn-off of the first switch transistor and to isolate parasitic capacitance generated by the first switch transistor.

In some embodiments, the at least one switch transistor includes a first switch transistor and a second switch transistor. The microwave unit includes a first microwave unit and a second microwave unit. The action of controlling, by the control unit, the transmitting terminal of the microwave unit to convert the control signal into the microwave signal and transmit the microwave signal to the receiving terminal of the microwave unit includes: controlling, by the control unit, a transmitting terminal of the first microwave unit to convert the control signal into a first microwave signal and transmit the first microwave signal to a receiving terminal of the first microwave unit; and controlling, by the control unit, a transmitting terminal of the second microwave unit to convert the control signal into a second microwave signal and transmit the second microwave signal to a receiving terminal of the second microwave unit. The action of controlling, by the control unit, the receiving terminal of the microwave unit to convert the microwave signal into the control signal to control the turn-on or the turn-off of the at least one switch transistor includes: controlling, by the control unit, the receiving terminal of the first microwave unit to convert the first microwave signal into the control signal to control turn-on or turn-off of the first switch transistor and to isolate parasitic capacitance generated by the first switch transistor; and controlling, by the control unit, the receiving terminal of the second microwave unit to convert the second microwave signal into the control signal to control turn-on or turn-off of the second switch transistor and to isolate parasitic capacitance generated by the second switch transistor.

In some embodiments, the at least one switch transistor includes a third switch transistor connected to a first microwave unit, a fourth switch transistor connected to the control unit, a fifth switch transistor, and a sixth switch transistor. The action of controlling, by the control unit, the transmitting terminal of the microwave unit to convert the control signal into the microwave signal and transmit the microwave signal to the receiving terminal of the microwave unit includes: controlling, by the control unit, a transmitting terminal of the first microwave unit to convert the control signal into a first microwave signal and transmit the first microwave signal to a receiving terminal of the first microwave unit. The action of controlling, by the control unit, the receiving terminal of the microwave unit to convert the microwave signal into the control signal to control the turn-on or the turn-off of the at least one switch transistor includes: controlling, by the control unit, the receiving terminal of the first microwave unit to convert the first microwave signal into the control signal to control turn-on or turn-off of the third switch transistor and/or the fifth switch transistor and to isolate parasitic capacitance generated by the third switch transistor and/or the fifth switch transistor.

In some embodiments, the at least one switch transistor includes a third switch transistor, a fourth switch transistor, a fifth switch transistor, and a sixth switch transistor. The microwave unit includes a first microwave unit and a second microwave unit. The action of controlling, by the control unit, the transmitting terminal of the microwave unit to convert the control signal into the microwave signal and transmit the microwave signal to the receiving terminal of the microwave unit includes: controlling, by the control unit, a transmitting terminal of the first microwave unit to convert the control signal into a first microwave signal and transmit the first microwave signal to a receiving terminal of the first microwave unit; and controlling, by the control unit, a transmitting terminal of the second microwave unit to convert the control signal into a second microwave signal and transmit the second microwave signal to a receiving terminal of the second microwave unit. The action of controlling, by the control unit, the receiving terminal of the microwave unit to convert the microwave signal into the control signal to control the turn-on or the turn-off of the at least one switch transistor includes: controlling, by the control unit, the receiving terminal of the first microwave unit to convert the first microwave signal into the control signal to control turn-on or turn-off of the third switch transistor and/or the fifth switch transistor and to isolate parasitic capacitance generated by the third switch transistor and/or the fifth switch transistor; and controlling, by the control unit, the receiving terminal of the second microwave unit to convert the second microwave signal into the control signal to control turn-on or turn-off of the fourth switch transistor and/or the sixth switch transistor and to isolate parasitic capacitance generated by the fourth switch transistor and/or the sixth switch transistor.

In some embodiments, the control unit includes a first control unit and a second control unit. The action of outputting, by the control unit, the control signal includes: outputting, by the first control unit, a first control signal to the first microwave unit, and controlling, by the first control unit, output time of the first control signal; and outputting, by the second control unit, a second control signal to the second microwave unit, and controlling, by the second control unit, output time of the second control signal.

In some embodiments, when the at least one switch transistor includes the first switch transistor and the second switch transistor, a time point of an output of a high level and/or a low level of the first control signal is different from a time point of an output of a high level and/or a low level of the second control signal, and the second switch transistor is turned on when the first switch transistor is completely turned off; or when the at least one switch transistor includes the third switch transistor, the fourth switch transistor, the fifth switch transistor, and the sixth switch transistor, an output of a high level and/or a low level of the first control signal is at a time point different from a time point of an output of a high level and/or a low level of the second control signal, and the fourth switch transistor and the sixth switch transistor are turned on when the third switch transistor and the fifth switch transistor are completely turned off.

In some embodiments, the first control unit is further configured to transmit a first synchronization signal to the second control unit and/or configured to receive a second synchronization signal transmitted by the second control unit, and the second control unit is further configured to transmit the second synchronization signal to the first control unit and/or configured to receive the first synchronization signal transmitted by the first control unit.

In some embodiments, dead time of the control signal is smaller than a first threshold.

In some embodiments, a predetermined frequency of the control signal is greater than a second threshold.

In some embodiments, the microwave unit includes an IC chip having an EHF antenna encapsulated in the IC chip.

The embodiments of the present disclosure further provide a computer-readable storage medium. The computer-readable storage medium stores computer-executable instructions. The computer-executable instructions are configured to perform the charging method 800 according to any of the above embodiments.

The embodiments of the present disclosure further provide a computer program product, which is an example useful for understanding the invention but outside the scope of the invention as claimed. The computer program product includes a computer program stored in a computer-readable storage medium. The computer program includes program instructions. The program instructions, when executed by a computer, cause the computer to perform the charging method 800 according to any of the above embodiments.

In the above embodiments, implementation may be made in whole or in part in software, hardware, firmware, or any combination thereof. When implemented by software, they can be implemented in the form of a computer program product in whole or in part. The computer program product includes one or more computer instructions. When the computer program instructions are loaded and executed on a computer, the processes or functions described in the embodiments of the present disclosure are provided in whole or in part. The computer may be a general-purpose computer, an application specific computer, a computer network, or any other programmable device. The computer instructions may be stored in a computer-readable storage medium or transmitted from one computer readable storage medium to another. For example, the computer instructions may be transmitted from one website, computer, server, or data center to another via a wired (such as coaxial cable, optical fiber, Digital Subscriber Line (DSL)) or wireless (such as infrared, wireless, microwave, etc.) connection. The computer readable storage medium may be any usable medium that can be accessed by a computer or a data storage device such as a server or a data center integrated with one or more usable medium. The usable medium may be a magnetic medium (for example, a floppy disk, a hard disk, a magnetic tape), an optical medium (for example, a Digital Video Disc (DVD)), or a semiconductor medium (for example, a Solid-State Disk (SSD)), etc. The usable medium may be a magnetic medium (for example, a floppy disk, a hard disk, a magnetic tape), an optical medium (for example, a Digital Video Disc (DVD)), or a semiconductor medium (for example, a Solid-State Disk (SSD)), etc.

It can be appreciated by those skilled in the art that the units and the steps of the algorithm of examples described in combination with the embodiments disclosed herein may be implemented in electronic hardware or a combination of computer software and electronic hardware. Whether these functions are executed in hardware or software depends on specific applications and design constraint conditions of technical solutions. For each specific application, professionals and technicians can use different methods to implement the described functions, but such implementation should not be considered beyond the scope of the present disclosure.

In several embodiments provided by the present disclosure, it should be understood that, the system, apparatuses and methods disclosed in several embodiments provided by the present disclosure can be implemented in any other ways. For example, the apparatus embodiments described above can be merely exemplary. For example, the units are merely divided based on logic functions. In practical implementation, the units can be divided in other manners. For example, multiple units or components can be combined or integrated into another system, or some features can be omitted or not executed. In addition, mutual coupling or direct coupling or communication connection described or discussed can be achieved via some interfaces, and indirect coupling or communication connection between apparatuses or units may be electrical, mechanical or of other forms.

In the present disclosure, while the terms "first", "second", etc., may be used to describe individual devices, these devices should not be limited by these terms. These terms are used only to distinguish one device from another. For example, without changing a meaning of description, a first device may be called a second device, and similarly, a second device may be called a first device, as long as all occurrences of "first device" are consistently renamed and all occurrences of "second device" are consistently renamed. Both the first device and the second device are devices, but may not be a same device.

The units illustrated as separate components can be or not be separated physically, and components described as display units can be or not be physical units, i.e., can be located at one position, or can be distributed onto multiple network units. It is possible to select some or all of the units according to actual needs, for achieving the objective of embodiments of the present disclosure.

In addition, respective functional units in respective embodiments of the present disclosure can be integrated into one processing unit, or can be present as separate physical entities. It is also possible to integrate two or more units into one unit.

The above description merely illustrates specific implementations of the present disclosure, but the scope of the present disclosure is not limited by the specific implementations. Any change or replacement within the technical scope disclosed by the present disclosure that can be easily conceived by a technical person familiar with the technical field of the present disclosure should fall in the scope of the present disclosure. The scope of the present disclosure is defined only by the claims as attached.

## Claims

1. A control circuit (200) for switch transistor control, the control circuit (200) comprising:
a control unit (210) configured to output a control signal; and
a microwave unit (220) having a transmitting terminal connected to the control unit (210), and a receiving terminal connected to at least one switch transistor (230), wherein the transmitting terminal of the microwave unit (220) is configured to convert the control signal into a microwave signal and transmit the microwave signal to the receiving terminal, and the receiving terminal of the microwave unit (220) is configured to convert the microwave signal into the control signal to control turn-on or turn-off of the at least one switch transistor (230);
**characterized in that**,
the microwave unit (220) comprises a first microwave unit (221), and the at least one switch transistor (230) comprises a first switch transistor (231) connected to the first microwave unit (221), and a second switch transistor (232) connected to the control unit (210), and
the first microwave unit (221) is connected between the control unit (210) and the first switch transistor (231), and configured to transmit the control signal to control turn-on or turn-off of the first switch transistor (231) and isolate parasitic capacitance generated by the first switch transistor (231).

2. The control circuit (200) according to claim 1, wherein the microwave unit (220) further comprises:
a second microwave unit (222) connected between the control unit (210) and the second switch transistor (232), the second microwave unit (222) being configured to transmit the control signal to control turn-on or turn-off of the second switch transistor (232) and isolate parasitic capacitance generated by the second switch transistor (232).

3. The control circuit (200) according to claim 1, wherein the at least one switch transistor (230) further comprises a fifth switch transistor (235) connected to the first microwave unit (221), and a sixth switch transistor (236) connected to the control unit (210), and
the first microwave unit (221) is further connected between the control unit (210) and the fifth switch transistor (235), and the first microwave unit (221) is further configured to transmit the control signal to control turn-on or turn-off of the fifth switch transistor (235), and isolate parasitic capacitance generated by the fifth switch transistor (235).

4. The control circuit (200) according to claim 1, wherein the at least one switch transistor (230) further comprises a fifth switch transistor (235), and a sixth switch transistor (236),
and the first microwave unit (221) is further connected between the control unit (210) and the fifth switch transistor (235), and the first microwave unit (221) is further configured to transmit the control signal to control turn-on or turn-off of the fifth switch transistor (235), and isolate parasitic capacitance generated by the fifth switch transistor (235); and
wherein the microwave unit (220) further comprises: a second microwave unit (222) connected between the control unit (210) and the second switch transistor (232) and between the control unit (210) and the sixth switch transistor (236), and the second microwave unit (222) is configured to transmit the control signal to control turn-on or turn-off of the second switch transistor (232) and/or the sixth switch transistor (236), and configured to isolate parasitic capacitance generated by the second switch transistor (232) and/or the sixth switch transistor (236).

5. The control circuit (200) according to claim 2 or 4, wherein the control unit (210) comprises:
a first control unit (211) connected to the first microwave unit (221), the first control unit (211) being configured to output a first control signal to the first microwave unit (221) and configured to control output time of the first control signal; and
a second control unit (212) connected to the second microwave unit (222), the second control unit (212) being configured to output a second control signal to the second microwave unit (222) and configured to control output time of the second control signal.

6. The control circuit (200) according to claim 5, wherein when the at least one switch transistor (230) comprises the first switch transistor (231) and the second switch transistor (232), a time point of an output of a high level and/or a low level of the first control signal is different from a time point of an output of a high level and/or a low level of the second control signal, and the second switch transistor (232) is turned on when the first switch transistor (231) is completely turned off; or
when the at least one switch transistor (230) comprises the first switch transistor (231), the second switch transistor (232), the fifth switch transistor (235), and the sixth switch transistor (236), a time point of an output of a high level and/or a low level of the first control signal is different from a time point of an output of a high level and/or a low level of the second control signal, and the second switch transistor (232) and the sixth switch transistor (236) are turned on when the first switch transistor (231) and the fifth switch transistor (235) are completely turned off.

7. The control circuit (200) according to claim 5 or 6, wherein the first control unit (211) is further configured to transmit a first synchronization signal to the second control unit (212) and/or configured to receive a second synchronization signal transmitted by the second control unit (212), and
wherein the second control unit (212) is further configured to transmit the second synchronization signal to the first control unit (211) and/or configured to receive the first synchronization signal transmitted by the first control unit (211).

8. A method (800) for switch transistor control, applied in a control circuit (200) comprising a control unit (210) and a microwave unit (220), the method comprising:
outputting (810), by the control unit (210), a control signal;
controlling (820), by the control unit (210), a transmitting terminal of the microwave unit (220) to convert the control signal into a microwave signal and transmit the microwave signal to a receiving terminal of the microwave unit (220); and
controlling (830), by the control unit (210), the receiving terminal of the microwave unit (220) to convert the microwave signal into the control signal to control turn-on or turn-off of at least one switch transistor (230);
**characterized in that**,
the microwave unit (220) comprises a first microwave unit (221); and the at least one switch transistor (230) comprises a first switch transistor (231) connected to the first microwave unit (221), and a second switch transistor (232) connected to the control unit (210), and
the controlling (820), by the control unit (210), the transmitting terminal of the microwave unit (220) to convert the control signal into the microwave signal and transmit the microwave signal to the receiving terminal of the microwave unit (220) comprises:
controlling, by the control unit (210), a transmitting terminal of the first microwave unit (221) to convert the control signal into a first microwave signal and transmit the first microwave signal to a receiving terminal of the first microwave unit (221), and
the controlling (830), by the control unit (210), the receiving terminal of the microwave unit (220) to convert the microwave signal into the control signal to control turn-on or turn-off of at least one switch transistor (230) comprises:
controlling, by the control unit (210), the receiving terminal of the first microwave unit (221) to convert the first microwave signal into the control signal to control turn-on or turn-off of the first switch transistor (231) and to isolate parasitic capacitance generated by the first switch transistor (231).

9. The method according to claim 8, wherein the microwave unit (220) further comprises a second microwave unit (222),
the controlling (820), by the control unit (210), the transmitting terminal of the microwave unit (220) to convert the control signal into the microwave signal and transmit the microwave signal to the receiving terminal of the microwave unit (220) further comprises:
controlling, by the control unit (210), a transmitting terminal of the second microwave unit (222) to convert the control signal into a second microwave signal and transmit the second microwave signal to a receiving terminal of the second microwave unit (222), and
the controlling (830), by the control unit (210), the receiving terminal of the microwave unit (220) to convert the microwave signal into the control signal to control the turn-on or the turn-off of the at least one switch transistor (230) further comprises:
controlling, by the control unit (210), the receiving terminal of the second microwave unit (222) to convert the second microwave signal into the control signal to control turn-on or turn-off of the second switch transistor (232) and to isolate parasitic capacitance generated by the second switch transistor (232).

10. The method according to claim 8, wherein the at least one switch transistor further comprises a fifth switch transistor (235) connected to the first microwave unit (221), and a sixth switch transistor (236) connected to the control unit (210),
the controlling (830), by the control unit (210), the receiving terminal of the microwave unit (220) to convert the microwave signal into the control signal to control the turn-on or the turn-off of the at least one switch transistor (230) further comprises:
controlling, by the control unit (210), the receiving terminal of the first microwave unit (221) to convert the first microwave signal into the control signal to control turn-on or turn-off of the fifth switch transistor (235) and to isolate parasitic capacitance generated by the fifth switch transistor (235).

11. The method according to claim 8, wherein the at least one switch transistor (230) comprises a fifth switch transistor (235) connected to the first microwave unit (221), and a sixth switch transistor (236), and the microwave unit (220) further comprises a second microwave unit (222) connected between the control unit (210) and the second switch transistor (232) and connected between the control unit (210) and the sixth switch transistor (236),
the controlling (820), by the control unit (210), the transmitting terminal of the microwave unit (220) to convert the control signal into the microwave signal and transmit the microwave signal to the receiving terminal of the microwave unit (220) further comprises:
controlling, by the control unit (210), a transmitting terminal of the second microwave unit (222) to convert the control signal into a second microwave signal and transmit the second microwave signal to a receiving terminal of the second microwave unit (222), and
the controlling, by the control unit (210), the receiving terminal of the microwave unit (220) to convert the microwave signal into the control signal to control the turn-on or the turn-off of the at least one switch transistor (230) further comprises:
controlling, by the control unit (210), the receiving terminal of the first microwave unit (221) to convert the first microwave signal into the control signal to control turn-on or turn-off of the fifth switch transistor (235) and to isolate parasitic capacitance generated by the fifth switch transistor (235); and
controlling, by the control unit (210), the receiving terminal of the second microwave unit (222) to convert the second microwave signal into the control signal to control turn-on or turn-off of the second switch transistor (232) and/or the sixth switch transistor (236) and to isolate parasitic capacitance generated by the second switch transistor (232) and/or the sixth switch transistor (236).

12. The method according to claim 9 or 11, wherein the control unit (210) comprises a first control unit (211) and a second control unit (212), and
the outputting (810), by the control unit (210), the control signal comprises:
outputting, by the first control unit (211), a first control signal to the first microwave unit (221), and controlling, by the first control unit (211), output time of the first control signal; and
outputting, by the second control unit (212), a second control signal to the second microwave unit (222), and controlling, by the second control unit (212), output time of the second control signal,
wherein when the at least one switch transistor (230) comprises the first switch transistor (231) and the second switch transistor (232), a time point of an output of a high level and/or a low level of the first control signal is different from a time point of an output of a high level and/or a low level of the second control signal, and the second switch transistor (232) is turned on when the first switch transistor (231) is completely turned off; or
when the at least one switch transistor (230) comprises the first switch transistor (231), the second switch transistor (232), the fifth switch transistor (235), and the sixth switch transistor (236), a time point of an output of a high level and/or a low level of the first control signal is different from a time point of an output of a high level and/or a low level of the second control signal, and the second switch transistor (232) and the sixth switch transistor (236) are turned on when the first switch transistor (231) and the fifth switch transistor (235) are completely turned off.

13. A computer-readable storage medium, having computer-executable instructions stored thereon, wherein the computer-executable instructions are configured to perform the method according to any one of claims 8 to 12.

## Patentansprüche

1. Steuerschaltung (200) zur Steuerung eines Schalttransistors, wobei die Steuerschaltung (200) Folgendes umfasst:
eine Steuereinheit (210), die konfiguriert ist, um ein Steuersignal auszugeben; und
eine Mikrowelleneinheit (220), die ein Sendeendgerät, das mit der Steuereinheit (210) verbunden ist, und ein Empfangsendgerät aufweist, das mit mindestens einem Schalttransistor (230) verbunden ist, wobei das Sendeendgerät der Mikrowelleneinheit (220) konfiguriert ist, um das Steuersignal in ein Mikrowellensignal umzuwandeln und das Mikrowellensignal an das Empfangsendgerät zu senden, und das Empfangsendgerät der Mikrowelleneinheit (220) konfiguriert ist, um das Mikrowellensignal in das Steuersignal umzuwandeln, um das Einschalten oder Ausschalten des mindestens einen Schalttransistors (230) zu steuern;
**dadurch gekennzeichnet, dass**
die Mikrowelleneinheit (220) eine erste Mikrowelleneinheit (221) umfasst, und der mindestens eine Schalttransistor (230) einen ersten Schalttransistor (231), der mit der ersten Mikrowelleneinheit (221) verbunden ist, und einen zweiten Schalttransistor (232) umfasst, der mit der Steuereinheit (210) verbunden ist, und
die erste Mikrowelleneinheit (221) zwischen der Steuereinheit (210) und dem ersten Schalttransistor (231) verbunden und konfiguriert ist, um das Steuersignal zu senden, um das Einschalten oder Ausschalten des ersten Schalttransistors (231) zu steuern und die von dem ersten Schalttransistor (231) erzeugte parasitäre Kapazität zu isolieren.

2. Steuerschaltung (200) nach Anspruch 1, wobei die Mikrowelleneinheit (220) weiter Folgendes umfasst:
eine zweite Mikrowelleneinheit (222), die zwischen der Steuereinheit (210) und dem zweiten Schalttransistor (232) verbunden ist, wobei die zweite Mikrowelleneinheit (222) konfiguriert ist, um das Steuersignal zu senden, um das Einschalten oder Ausschalten des zweiten Schalttransistors (232) zu steuern und die von dem zweiten Schalttransistor (232) erzeugte parasitäre Kapazität zu isolieren.

3. Steuerschaltung (200) nach Anspruch 1, wobei der mindestens eine Schalttransistor (230) weiter einen fünften Schalttransistor (235), der mit der ersten Mikrowelleneinheit (221) verbunden ist, und einen sechsten Schalttransistor (236) umfasst, der mit der Steuereinheit (210) verbunden ist, und
wobei die erste Mikrowelleneinheit (221) weiter zwischen der Steuereinheit (210) und dem fünften Schalttransistor (235) verbunden ist, und die erste Mikrowelleneinheit (221) weiter konfiguriert ist, um das Steuersignal zu senden, um das Einschalten oder Ausschalten des fünften Schalttransistors (235) zu steuern und die von dem fünften Schalttransistor (235) erzeugte parasitäre Kapazität zu isolieren.

4. Steuerschaltung (200) nach Anspruch 1, wobei der mindestens eine Schalttransistor (230) weiter einen fünften Schalttransistor (235) und einen sechsten Schalttransistor (236) umfasst, und
wobei die erste Mikrowelleneinheit (221) weiter zwischen der Steuereinheit (210) und dem fünften Schalttransistor (235) verbunden ist, und die erste Mikrowelleneinheit (221) weiter konfiguriert ist, um das Steuersignal zu senden, um das Einschalten oder Ausschalten des fünften Schalttransistors (235) zu steuern und die von dem fünften Schalttransistor (235) erzeugte parasitäre Kapazität zu isolieren; und
wobei die Mikrowelleneinheit (220) weiter Folgendes umfasst: eine zweite Mikrowelleneinheit (222), die zwischen der Steuereinheit (210) und dem zweiten Schalttransistor (232) und zwischen der Steuereinheit (210) und dem sechsten Schalttransistor (236) verbunden ist, und die zweite Mikrowelleneinheit (222) konfiguriert ist, um das Steuersignal zu senden, um das Einschalten oder Ausschalten des zweiten Schalttransistors (232) und/oder des sechsten Schalttransistor (236) zu steuern, und konfiguriert ist, um die von dem zweiten Schalttransistor (232) und/oder dem sechsten Schalttransistor (236) erzeugte parasitäre Kapazität zu isolieren.

5. Steuerschaltung (200) nach Anspruch 2 oder 4, wobei die Steuereinheit (210) Folgendes umfasst:
eine erste Steuereinheit (211), die mit der ersten Mikrowelleneinheit (221) verbunden ist, wobei die erste Steuereinheit (211) konfiguriert ist, um ein erstes Steuersignal an die erste Mikrowelleneinheit (221) auszugeben, und konfiguriert ist, um eine Ausgabezeit des ersten Steuersignals zu steuern; und
eine zweite Steuereinheit (212), die mit der zweiten Mikrowelleneinheit (222) verbunden ist, wobei die zweite Steuereinheit (212) konfiguriert ist, um ein zweites Steuersignal an die zweite Mikrowelleneinheit (222) auszugeben, und konfiguriert ist, um eine Ausgabezeit des zweiten Steuersignals zu steuern.

6. Steuerschaltung (200) nach Anspruch 5, wobei, wenn der mindestens eine Schalttransistor (230) den ersten Schalttransistor (231) und den zweiten Schalttransistor (232) umfasst, ein Zeitpunkt einer Ausgabe eines hohen Pegels und/oder eines niedrigen Pegels des ersten Steuersignals sich von einem Zeitpunkt einer Ausgabe eines hohen Pegels und/oder eines niedrigen Pegels des zweiten Steuersignals unterscheidet, und der zweite Schalttransistor (232) eingeschaltet wird, wenn der erste Schalttransistor (231) vollständig ausgeschaltet ist; oder
wenn der mindestens eine Schalttransistor (230) den ersten Schalttransistor (231), den zweiten Schalttransistor (232), den fünften Schalttransistor (235) und den sechsten Schalttransistor (236) umfasst, ein Zeitpunkt einer Ausgabe eines hohen Pegels und/oder eines niedrigen Pegels des ersten Steuersignals sich von einem Zeitpunkt einer Ausgabe eines hohen Pegels und/oder eines niedrigen Pegels des zweiten Steuersignals unterscheidet, und der zweite Schalttransistor (232) und der sechste Schalttransistor (236) eingeschaltet werden, wenn der erste Schalttransistor (231) und der fünfte Schalttransistor (235) vollständig ausgeschaltet sind.

7. Steuerschaltung (200) nach Anspruch 5 oder 6, wobei die erste Steuereinheit (211) weiter konfiguriert ist, um ein erstes Synchronisationssignal an die zweite Steuereinheit (212) zu senden und/oder konfiguriert ist, um ein zweites Synchronisationssignal zu empfangen, das von der zweiten Steuereinheit (212) gesendet wird, und
wobei die zweite Steuereinheit (212) weiter konfiguriert ist, um das zweite Synchronisationssignal an die erste Steuereinheit (211) zu senden und/oder konfiguriert ist, um das erste Synchronisationssignal, das von der ersten Steuereinheit (211) gesendet wird, zu empfangen.

8. Verfahren (800) zur Steuerung eines Schalttransistors, angewendet in einer Steuerschaltung (200), die eine Steuereinheit (210) und eine Mikrowelleneinheit (220) umfasst, wobei das Verfahren Folgendes umfasst:
Ausgeben (810), durch die Steuereinheit (210), eines Steuersignals;
Steuern (820), durch die Steuereinheit (210), eines Sendeendgerätes der Mikrowelleneinheit (220), um das Steuersignal in ein Mikrowellensignal umzuwandeln und das Mikrowellensignal an ein Empfangsendgerät der Mikrowelleneinheit (220) zu senden; und
Steuern (830), durch die Steuereinheit (210), des Empfangsendgerätes der Mikrowelleneinheit (220), um das Mikrowellensignal in das Steuersignal umzuwandeln, um das Einschalten oder Ausschalten von mindestens einem Schalttransistor (230) zu steuern;
**dadurch gekennzeichnet, dass**
die Mikrowelleneinheit (220) eine erste Mikrowelleneinheit (221) umfasst; und der mindestens eine Schalttransistor (230) einen ersten Schalttransistor (231), der mit der ersten Mikrowelleneinheit (221) verbunden ist, und einen zweiten Schalttransistor (232) umfasst, der mit der Steuereinheit (210) verbunden ist, und
das Steuern (820), durch die Steuereinheit (210), des Sendeendgerätes der Mikrowelleneinheit (220), um das Steuersignal in das Mikrowellensignal umzuwandeln und das Mikrowellensignal an das Empfangsendgerät der Mikrowelleneinheit (220) zu senden, Folgendes umfasst:
Steuern, durch die Steuereinheit (210), eines Sendeendgerätes der ersten Mikrowelleneinheit (221), um das Steuersignal in ein erstes Mikrowellensignal umzuwandeln und das erste Mikrowellensignal an ein Empfangsendgerät der ersten Mikrowelleneinheit (221) zu senden, und
das Steuern (830), durch die Steuereinheit (210), des Empfangsendgerätes der Mikrowelleneinheit (220), um das Mikrowellensignal in das Steuersignal umzuwandeln, um das Einschalten oder Ausschalten mindestens eines Schalttransistors (230) zu steuern, Folgendes umfasst:
Steuern, durch die Steuereinheit (210), des Empfangsendgerätes der ersten Mikrowelleneinheit (221), um das erste Mikrowellensignal in das Steuersignal umzuwandeln, um das Einschalten oder Ausschalten des ersten Schalttransistors (231) zu steuern und die von dem ersten Schalttransistor (231) erzeugte parasitäre Kapazität zu isolieren.

9. Verfahren nach Anspruch 8, wobei die Mikrowelleneinheit (220) weiter eine zweite Mikrowelleneinheit (222) umfasst,
wobei das Steuern (820), durch die Steuereinheit (210), des Sendeendgerätes der Mikrowelleneinheit (220), um das Steuersignal in das Mikrowellensignal umzuwandeln und das Mikrowellensignal an das Empfangsendgerät der Mikrowelleneinheit (220) zu senden, weiter Folgendes umfasst:
Steuern, durch die Steuereinheit (210), eines Sendeendgerätes der zweiten Mikrowelleneinheit (222), um das Steuersignal in ein zweites Mikrowellensignal umzuwandeln und das zweite Mikrowellensignal an ein Empfangsendgerät der zweiten Mikrowelleneinheit (222) zu senden, und
das Steuern (830), durch die Steuereinheit (210), des Empfangsendgerätes der Mikrowelleneinheit (220), um das Mikrowellensignal in das Steuersignal umzuwandeln, um das Einschalten oder das Ausschalten des mindestens eines Schalttransistors (230) zu steuern, weiter Folgendes umfasst:
Steuern, durch die Steuereinheit (210), des Empfangsendgeräts der zweiten Mikrowelleneinheit (222), um das zweite Mikrowellensignal in ein Steuersignal umzuwandeln, um das Einschalten oder Ausschalten des zweiten Schalttransistors (232) zu steuern und die von dem zweiten Schalttransistor (232) erzeugte parasitäre Kapazität zu isolieren.

10. Verfahren nach Anspruch 8, wobei der mindestens eine Schalttransistor weiter einen fünften Schalttransistor (235), der mit der ersten Mikrowelleneinheit (221) verbunden ist, und einen sechsten Schalttransistor (236) umfasst, der mit der Steuereinheit (210) verbunden ist,
wobei das Steuern (830), durch die Steuereinheit (210), des Empfangsendgerätes der Mikrowelleneinheit (220), um das Mikrowellensignal in das Steuersignal umzuwandeln, um das Einschalten oder das Ausschalten des mindestens eines Schalttransistors (230) zu steuern, weiter Folgendes umfasst:
Steuern, durch die Steuereinheit (210), des Empfangsendgerätes der ersten Mikrowelleneinheit (221), um das erste Mikrowellensignal in das Steuersignal umzuwandeln, um das Einschalten oder Ausschalten des fünften Schalttransistors (235) zu steuern und die von dem fünften Schalttransistor (235) erzeugte parasitäre Kapazität zu isolieren.

11. Verfahren nach Anspruch 8, wobei der mindestens eine Schalttransistor (230) einen fünften Schalttransistor (235), der mit der ersten Mikrowelleneinheit (221) verbunden ist, und einen sechsten Schalttransistor (236) umfasst, und wobei die Mikrowelleneinheit (220) weiter eine zweite Mikrowelleneinheit (222) umfasst, die zwischen der Steuereinheit (210) und dem zweiten Schalttransistor (232) verbunden ist und zwischen der Steuereinheit (210) und dem sechsten Schalttransistor (236) verbunden ist,
wobei das Steuern (820), durch die Steuereinheit (210), des Sendeendgerätes der Mikrowelleneinheit (220), um das Steuersignal in das Mikrowellensignal umzuwandeln und das Mikrowellensignal an das Empfangsendgerät der Mikrowelleneinheit (220) zu senden, weiter Folgendes umfasst:
Steuern, durch die Steuereinheit (210), eines Sendeendgerätes der zweiten Mikrowelleneinheit (222), um das Steuersignal in ein zweites Mikrowellensignal umzuwandeln und das zweite Mikrowellensignal an ein Empfangsendgerät der zweiten Mikrowelleneinheit (222) zu senden, und
wobei das Steuern, durch die Steuereinheit (210), des Empfangsendgerätes der Mikrowelleneinheit (220), um das Mikrowellensignal in das Steuersignal umzuwandeln, um das Einschalten oder das Ausschalten des mindestens eines Schalttransistors (230) zu steuern, weiter Folgendes umfasst:
Steuern, durch die Steuereinheit (210), des Empfangsendgerätes der ersten Mikrowelleneinheit (221), um das erste Mikrowellensignal in das Steuersignal umzuwandeln, um das Einschalten oder Ausschalten des fünften Schalttransistors (235) zu steuern und die von dem fünften Schalttransistor (235) erzeugte parasitäre Kapazität zu isolieren; und
Steuern, durch die Steuereinheit (210), des Empfangsendgerätes der zweiten Mikrowelleneinheit (222), um das zweite Mikrowellensignal in das Steuersignal umzuwandeln, um das Einschalten oder Ausschalten des zweiten Schalttransistors (232) und/oder des sechsten Schalttransistors (236) zu steuern und die von dem zweiten Schalttransistor (232) und/oder dem sechsten Schalttransistor (236) erzeugte parasitäre Kapazität zu isolieren.

12. Verfahren nach Anspruch 9 oder 11, wobei die Steuereinheit (210) eine erste Steuereinheit (211) und eine zweite Steuereinheit (212) umfasst, und
das Ausgeben (810), durch die Steuereinheit (210), des Steuersignals Folgendes umfasst:
Ausgeben, durch die erste Steuereinheit (211), eines ersten Steuersignals an die erste Mikrowelleneinheit (221) und Steuern, durch die erste Steuereinheit (211), der Ausgabezeit des ersten Steuersignals; und
Ausgeben, durch die zweite Steuereinheit (212), eines zweiten Steuersignals an die zweite Mikrowelleneinheit (222) und Steuern, durch die zweite Steuereinheit (212), der Ausgabezeit des zweiten Steuersignals,
wobei, wenn der mindestens eine Schalttransistor (230) den ersten Schalttransistor (231) und den zweiten Schalttransistor (232) umfasst, ein Zeitpunkt einer Ausgabe eines hohen Pegels und/oder eines niedrigen Pegels des ersten Steuersignals sich von einem Zeitpunkt einer Ausgabe eines hohen Pegels und/oder eines niedrigen Pegels des zweiten Steuersignals unterscheidet, und der zweite Schalttransistor (232) eingeschaltet wird, wenn der erste Schalttransistor (231) vollständig ausgeschaltet ist; oder
wenn der mindestens eine Schalttransistor (230) den ersten Schalttransistor (231), den zweiten Schalttransistor (232), den fünften Schalttransistor (235) und den sechsten Schalttransistor (236) umfasst, ein Zeitpunkt einer Ausgabe eines hohen Pegels und/oder eines niedrigen Pegels des ersten Steuersignals sich von einem Zeitpunkt einer Ausgabe eines hohen Pegels und/oder eines niedrigen Pegels des zweiten Steuersignals unterscheidet, und der zweite Schalttransistor (232) und der sechste Schalttransistor (236) eingeschaltet werden, wenn der erste Schalttransistor (231) und der fünfte Schalttransistor (235) vollständig ausgeschaltet sind.

13. Computerlesbares Speichermedium, das darauf gespeicherte computerausführbare Anweisungen aufweist, wobei die computerausführbaren Anweisungen konfiguriert sind, um das Verfahren nach einem der Ansprüche 8 bis 12 durchzuführen.

## Revendications

1. Circuit de commande (200) pour la commande d'un transistor de commutation, le circuit de commande (200) comprenant :
une unité de commande (210) configurée pour délivrer en sortie un signal de commande ; et
une unité à micro-ondes (220) présentant une borne d'émission connectée à l'unité de commande (210) et une borne de réception connectée à au moins un transistor de commutation (230), dans lequel la borne d'émission de l'unité à micro-ondes (220) est configurée pour convertir le signal de commande en un signal micro-ondes et émettre le signal micro-ondes à la borne de réception, et la borne de réception de l'unité à micro-ondes (220) est configurée pour convertir le signal micro-ondes en le signal de commande afin de commander l'activation ou la désactivation de l'au moins un transistor de commutation (230) ;
**caractérisé en ce que**
l'unité à micro-ondes (220) comprend une première unité à micro-ondes (221), et le au moins un transistor de commutation (230) comprend un premier transistor de commutation (231) connecté à la première unité à micro-ondes (221), et un deuxième transistor de commutation (232) connecté à l'unité de commande (210), et
la première unité à micro-ondes (221) est connectée entre l'unité de commande (210) et le premier transistor de commutation (231), et configurée pour émettre le signal de commande afin de commander l'activation ou la désactivation du premier transistor de commutation (231) et d'isoler la capacité parasite générée par le premier transistor de commutation (231).

2. Circuit de commande (200) selon la revendication 1, dans lequel l'unité à micro-ondes (220) comprend en outre :
une seconde unité à micro-ondes (222) connectée entre l'unité de commande (210) et le deuxième transistor de commutation (232), la seconde unité à micro-ondes (222) étant configurée pour émettre le signal de commande afin de commander l'activation ou la désactivation du deuxième transistor de commutation (232) et d'isoler la capacité parasite générée par le deuxième transistor de commutation (232).

3. Circuit de commande (200) selon la revendication 1, dans lequel le au moins un transistor de commutation (230) comprend en outre un cinquième transistor de commutation (235) connecté à la première unité à micro-ondes (221), et un sixième transistor de commutation (236) connecté à l'unité de commande (210), et
la première unité à micro-ondes (221) est en outre connectée entre l'unité de commande (210) et le cinquième transistor de commutation (235), et la première unité à micro-ondes (221) est en outre configurée pour émettre le signal de commande afin de commander l'activation ou la désactivation du cinquième transistor de commutation (235) et d'isoler la capacité parasite générée par le cinquième transistor de commutation (235).

4. Circuit de commande (200) selon la revendication 1, dans lequel le au moins un transistor de commutation (230) comprennent en outre un cinquième transistor de commutation (235) et un sixième transistor de commutation (236), et
la première unité à micro-ondes (221) est en outre connectée entre l'unité de commande (210) et le cinquième transistor de commutation (235), et la première unité à micro-ondes (221) est en outre configurée pour émettre le signal de commande afin de commander l'activation ou la désactivation du cinquième transistor de commutation (235), et d'isoler la capacité parasite générée par le cinquième transistor de commutation (235) ; et
dans lequel l'unité à micro-ondes (220) comprend en outre : une seconde unité à micro-ondes (222) connectée entre l'unité de commande (210) et le deuxième transistor de commutation (232) et entre l'unité de commande (210) et le sixième transistor de commutation (236), et la seconde unité à micro-ondes (222) est configurée pour émettre le signal de commande afin de commander l'activation ou la désactivation du deuxième transistor de commutation (232). et/ou du sixième transistor de commutation (236), et configuré pour isoler la capacité parasite générée par le deuxième transistor de commutation (232) et/ou le sixième transistor de commutation (236).

5. Circuit de commande (200) selon la revendication 2 ou 4, dans lequel l'unité de commande (210) comprend :
une première unité de commande (211) connectée à la première unité à micro-ondes (221), la première unité de commande (211) étant configurée pour délivrer en sortie un premier signal de commande vers la première unité à micro-ondes (221) et configurée pour commander la durée de délivrance en sortie du premier signal de commande ; et
une seconde unité de commande (212) connectée à la seconde unité à micro-ondes (222), la seconde unité de commande (212) étant configurée pour délivrer en sortie un second signal de commande à la seconde unité à micro-ondes (222) et configurée pour commander le temps de délivrance en sortie du second signal de commande.

6. Circuit de commande (200) selon la revendication 5, dans lequel lorsque le au moins un transistor de commutation (230) comprend le premier transistor de commutation (231) et le deuxième transistor de commutation (232), un instant d'une délivrance en sortie d'à un niveau haut de sortie et/ou d'un niveau bas du premier signal de commande est différent d'un instant de délivrance en sortie d'un niveau haut et/ou d'un niveau bas du second signal de commande, et le deuxième transistor de commutation (232) est activé lorsque le premier transistor de commutation (231) est complètement désactivé ; ou
lorsque le au moins un transistor de commutation (230) comprend le premier transistor de commutation (231), le deuxième transistor de commutation (232), le cinquième transistor de commutation (235) et le sixième transistor de commutation (236), un instant d'une délivrance en sortie d'un niveau haut et/ou d'un niveau bas du premier signal de commande est différent d'un instant de délivrance en sortie d'un niveau haut et/ou d'un niveau bas du deuxième signal de commande, et le deuxième transistor de commutation (232) et le sixième transistor de commutation (236) sont activés lorsque le premier transistor de commutation (231) et le cinquième transistor de commutation (235) sont complètement désactivés.

7. Circuit de commande (200) selon la revendication 5 ou 6, dans lequel la première unité de commande (211) est en outre configurée pour émettre un premier signal de synchronisation vers la seconde unité de commande (212) et/ou configurée pour recevoir un second signal de synchronisation émis par la seconde unité de commande (212), et
dans lequel la seconde unité de commande (212) est en outre configurée pour émettre le second signal de synchronisation vers la première unité de commande (211) et/ou configuré pour recevoir le premier signal de synchronisation émis par la première unité de commande (211).

8. Procédé (800) pour la commande d'un transistor de commutation, appliqué dans un circuit de commande (200) comprenant une unité de commande (210) et une unité à micro-ondes (220), le procédé comprenant :
la délivrance en sortie (810), par l'intermédiaire de l'unité de commande (210), d'un signal de commande;
la commande (820), par l'intermédiaire de l'unité de commande (210), d'une borne d'émission de l'unité à micro-ondes (220) afin de convertir le signal de commande en un signal micro-ondes et d'émettre ce signal micro-ondes à une borne de réception de l'unité à micro-ondes (220) ; et
la commande (830), par l'intermédiaire de l'unité de commande (210), de la borne de réception de l'unité à micro-ondes (220) pour convertir le signal micro-ondes en le signal de commande pour commander l'activation ou la désactivation d'au moins un transistor de commutation (230) ;
**caractérisé en ce que**
l'unité à micro-ondes (220) comprend une première unité à micro-ondes (221), et le au moins un transistor de commutation (230) comprend un premier transistor de commutation (231) connecté à la première unité à micro-ondes (221), et un deuxième transistor de commutation (232) connecté à l'unité de commande (210), et
la commande (820), par l'intermédiaire de l'unité de commande (210), de la borne d'émission de l'unité à micro-ondes (220) pour convertir le signal de commande en le signal micro-ondes et émettre le signal micro-ondes vers la borne de réception de l'unité à micro-ondes (220) comprend :
la commande, par l'intermédiaire de l'unité de commande (210), d'une borne d'émission de la première unité à micro-ondes (221) afin de convertir le signal de commande en un premier signal micro-ondes et d'émettre le premier signal micro-ondes vers une borne de réception de la première unité à micro-ondes (221).
la commande (830), par l'intermédiaire de l'unité de commande (210), de la borne de réception de l'unité à micro-ondes (220) pour convertir le signal micro-ondes en le signal de commande pour commander l'activation ou la désactivation d'au moins un transistor de commutation (230) comprend :
la commande, par l'intermédiaire de l'unité de commande (210), de la borne de réception de la première unité à micro-ondes (221) pour convertir le premier signal micro-ondes en le signal de commande pour commander l'activation ou la désactivation du premier transistor de commutation (231) et pour isoler la capacité parasite générée par le premier transistor de commutation (231).

9. Procédé selon la revendication 8, dans lequel l'unité à micro-ondes (220) comprend en outre une seconde unité à micro-ondes (222),
la commande (820), par l'intermédiaire de l'unité de commande (210), de la borne d'émission de l'unité à micro-ondes (220) pour convertir le signal de commande en le signal micro-ondes et émettre le signal micro-ondes vers la borne de réception de l'unité à micro-ondes (220) comprend en outre :
la commande, par l'intermédiaire de l'unité de commande (210), d'une borne d'émission de la seconde unité à micro-ondes (222) afin de convertir le signal de commande en un second signal micro-ondes et d'émettre le second signal micro-ondes vers une borne de réception de la seconde unité à micro-ondes (222), et
la commande (830), par l'intermédiaire de l'unité de commande (210), de la borne de réception de l'unité à micro-ondes (220) pour convertir le signal micro-ondes en le signal de commande pour commander l'activation ou la désactivation de l'au moins un transistor de commutation (230) comprend en outre :
la commande, par l'intermédiaire de l'unité de commande (210), de la borne de réception de la seconde unité à micro-ondes (222) pour convertir le seconde signal micro-ondes en le signal de commande pour commander l'activation ou la désactivation du deuxième transistor de commutation (232) et pour isoler la capacité parasite générée par le deuxième transistor de commutation (232).

10. Le procédé selon la revendication 8, dans lequel le au moins un transistor de commutation comprennent en outre un cinquième transistor de commutation (235) connecté à la première unité à micro-ondes (221), et un sixième transistor de commutation (236) connecté à l'unité de commande (210),
la commande (830), par l'intermédiaire de l'unité de commande (210), de la borne de réception de l'unité à micro-ondes (220) pour convertir le signal micro-ondes en le signal de commande pour commander l'activation ou la désactivation de l'au moins un transistor de commutation (230) comprend en outre :
la commander, par l'intermédiaire de l'unité de commande (210), de la borne de réception de la première unité à micro-ondes (221) pour convertir le premier signal micro-ondes en le signal de commande pour commander l'activation ou la désactivation du cinquième transistor de commutation (235) et pour isoler la capacité parasite générée par le cinquième transistor de commutation (235).

11. Procédé selon la revendication 8, dans lequel le au moins un transistor de commutation (230) comprend un cinquième transistor de commutation (235) connecté à la première unité à micro-ondes (221), et un sixième transistor de commutation (236), et l'unité à micro-ondes (220) comprend en outre une seconde unité à micro-ondes (222) connectée entre l'unité de commande (210) et le deuxième transistor de commutation (232) et connectée entre l'unité de commande (210) et le sixième transistor de commutation (236),
la commande (820), par l'intermédiaire de l'unité de commande (210), de la borne d'émission de l'unité à micro-ondes (220) pour convertir le signal de commande en le signal micro-ondes et émettre le signal micro-ondes vers la borne de réception de l'unité à micro-ondes (220) comprend en outre :
la commander, par l'intermédiaire de l'unité de commande (210), d'une borne d'émission de la seconde unité à micro-ondes (222) afin de convertir le signal de commande en un second signal micro-ondes et d'émettre le second signal micro-ondes vers une borne de réception de la seconde unité à micro-ondes (222), et
la commande, par l'intermédiaire de l'unité de commande (210), de la borne de réception de l'unité à micro-ondes (220) pour convertir le signal micro-ondes en le signal de commande pour commander l'activation ou la désactivation de l'au moins un transistor de commutation (230) comprend en outre :
la commande, par l'intermédiaire de l'unité de commande (210), de la borne de réception de la première unité à micro-ondes (221) pour convertir le premier signal micro-ondes en le signal de commande pour commander l'activation ou la désactivation du cinquième transistor de commutation (235) et pour isoler la capacité parasite générée par le cinquième transistor de commutation (235) ; et
la commande, par l'intermédiaire de l'unité de commande (210), de la borne de réception de la seconde unité à micro-ondes (222) pour convertir le deuxième signal micro-ondes en le signal de commande pour commander l'activation ou la désactivation du deuxième transistor de commutation (232) et/ou du sixième transistor de commutation (236) et pour isoler la capacité parasite générée par le deuxième transistor de commutation (232) et/ou le sixième transistor de commutation (236).

12. Procédé selon la revendication 9 ou 11, dans lequel l'unité de commande (210) comprend une première unité de commande (211) et une seconde unité de commande (212), et
la délivrance en sortie (810), par l'intermédiaire de l'unité de commande (210), du signal de commande comprend :
la délivrance en sortie, par l'intermédiaire de la première unité de commande (211), d'un premier signal de commande vers la première unité à micro-ondes (221), et la commande, par l'intermédiaire de la première unité de commande (211), de la durée de délivrance en sortie du premier signal de commande ; et
la délivrance en sortie, par l'intermédiaire de la seconde unité de commande (212), d'un second signal de commande vers la seconde unité à micro-ondes (222), et la commande, par l'intermédiaire de la seconde unité de commande (212), de la durée de délivrance en sortie du second signal de commande,
dans lequel lorsque le au moins un transistor de commutation (230) comprend le premier transistor de commutation (231) et le deuxième transistor de commutation (232), un instant d'une délivrance en sortie d'à un niveau haut de sortie et/ou d'un niveau bas du premier signal de commande est différent d'un instant de délivrance en sortie d'un niveau haut et/ou d'un niveau bas du second signal de commande, et le deuxième transistor de commutation (232) est activé lorsque le premier transistor de commutation (231) est complètement désactivé ; ou
lorsque le au moins un transistor de commutation (230) comprend le premier transistor de commutation (231), le deuxième transistor de commutation (232), le cinquième transistor de commutation (235) et le sixième transistor de commutation (236), un instant d'une délivrance en sortie d'un niveau haut et/ou d'un niveau bas du premier signal de commande est différent d'un instant de délivrance en sortie d'un niveau haut et/ou d'un niveau bas du deuxième signal de commande, et le deuxième transistor de commutation (232) et le sixième transistor de commutation (236) sont activés lorsque le premier transistor de commutation (231) et le cinquième transistor de commutation (235) sont complètement désactivés.

13. Support de stockage lisible par ordinateur, sur lequel sont stockées des instructions exécutables par ordinateur, dans lequel les instructions exécutables par ordinateur sont configurées pour exécuter le procédé selon l'une quelconque des revendications 8 à 12.
